# EUROPEAN PATENT APPLICATION

(11) **EP 4 404 235 A2**
(43) Date of publication of application: **24.07.2024**
(21) Application number: 23216424.4
(22) Date of filing: 13.12.2023
(51) Int. Cl.: H01J 37/26, H01J 37/20, H01J 37/28, H01J 49/08

(54) **COLLISION JUDGMENT APPARATUS, RECORDING MEDIUM RECORDING PROGRAM, AND COLLISION JUDGMENT METHOD**

(30) Priority: 22.12.2022 JP 2022205954
(71) Applicant: JEOL Ltd., Akishima, Tokyo 196-8558 (JP)
(72) Inventor: HAYASHI, Kohei, Tokyo 196-8558 (JP); KAKEYA, Takumi, Tokyo 196-8558 (JP)
(74) Representative: Boult Wade Tennant LLP

(57) **Abstract**

Based on a three-dimensional model of a dynamic object having a position which changes, point group information which represents, with a group of points, a three-dimensional shape of the dynamic object is generated. Based on a three-dimensional model of a static object having a position which does not change, point group information representing, with a group of points, a three-dimensional shape of the static object is generated. Based on the point group information of the static object, voxel group information which represents, with a group of voxels, the three-dimensional shape of the static object, and which is formed into a database is generated. Presence or absence of overlap between the dynamic object and the static object is judged by collating voxel group information representing the static object which is present on a movement path of the dynamic object, and point group information representing the dynamic object.

## Description

### CROSS REFERENCE TO RELATED APPLICATION

This application claims priority to Japanese Patent Application No. 2022-205954 filed on December 22, 2022, which is incorporated herein by reference in its entirety including the specification, claims, drawings, and abstract.

### TECHNICAL FIELD

The present disclosure relates to a technique to judge collision between structures present in a sample chamber of a charged particle beam apparatus.

### BACKGROUND

Charged particle beam apparatuses are known, including electron microscopes (for example, scanning electron microscopes (SEM) and transmission electron microscopes (TEM)), focused ion beam (FIB) apparatuses, auger electron spectroscopy (AED) apparatuses, and the like.

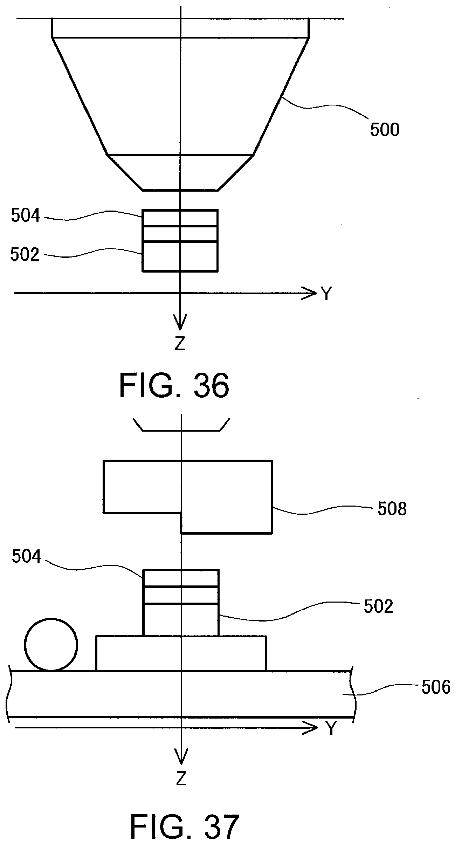

There is known a technique to judge presence or absence of collision between structures present in a sample chamber of a charged particle beam apparatus. A collision judgment method of the related art will now be described with reference to FIGs. 36 to 38. An X axis, a Y axis, and a Z axis are defined, which are orthogonal to each other.

FIG. 36 shows an objective lens 500, a sample holder 502, and a sample 504 mounted on the sample holder 502. The objective lens 500, the sample holder 502, and the sample 504 are examples of structures present in the sample chamber. FIG. 36 shows the structures viewed in a Y-Z plane.

In the related art, the objective lens 500 is represented with a polygon and the sample holder 502 is represented with a rectangle in the two-dimensional, Y-Z plane, and it is judged whether or not the objective lens 500 and the sample holder 502 collide with each other on the Y-Z plane. In addition, one height is set as a height of the sample 504, and it is judged whether or not the objective lens 500 and the sample 504 collide with each other on the Y-Z plane. When a plurality of samples are mounted on the sample holder 502, a height of a sample having the greatest height among the plurality of samples is set as the height of the sample, and it is judged whether or not the objective lens 500 and the samples collide with each other.

FIG. 37 shows the sample holder 502, the sample 504, a stage 506, and a detector 508. FIG. 37 shows the structures viewed on the Y-Z plane.

The detector 508 is one example of a structure that reciprocates. Such a detector 508 is represented with two rectangles having one side contacting the Z axis on the Y-Z plane. In addition, the sample holder 502 is represented with a rectangle and the stage 506 is represented with two rectangles and one circle on the Y-Z plane. In the related art, it is judged whether or not these structures collide with each other on the Y-Z plane.

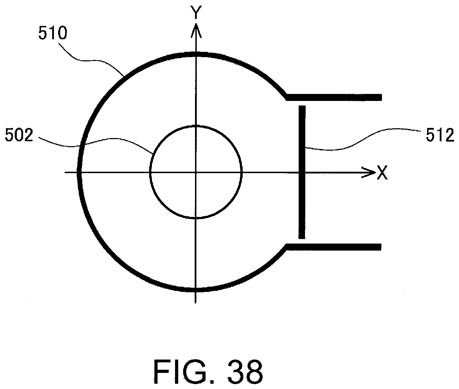

FIG. 38 shows the sample holder 502, a wall surface 510 of the sample chamber, and a stage 512. FIG. 38 shows the structures viewed in an X-Y plane.

The wall surface 510 of the sample chamber is represented with a combination of an arc and a line segment, and the sample holder 502 is represented with a circle on the X-Y plane. In the related art, movable ranges for the sample holder 502 and the stage 512 are determined in advance, and it is judged whether or not these structures collide with each other on the X-Y plane.

JP 2726811 B and JP 2021-24019 A disclose a system in which an object is represented using voxels, and presence or absence of collisions between the objects is judged.

In the related art, the presence or absence of collision between the structures is judged in the two-dimensional plane, and a depth is not taken into consideration. Because of this, when it is judged that the structures overlap each other in the two-dimensional plane, it is judged that the structures collide with each other, even when the structures do not actually collide with each other.

Further, in the related art, the presence or absence of collision is judged using two-dimensional shapes that are determined in advance. For example, a shape which is larger than the actual structure is determined, and the presence or absence of collision is judged. Because of this, there may be cases in which it is judged that the structures collide with each other, even when the structures do not collide with each other in reality.

If it is possible to judge presence or absence of collision before the structures are actually moved, the collision between the structures can be avoided in advance. Thus, it is desired to enable judgment of the presence or absence of collision before the structures are actually moved.

An advantage of the present disclosure lies in a more accurate judgment of presence or absence of collision in comparison to the case of judgment of the presence or absence of collision between structures in the two-dimensional plane. Alternatively, an advantage of the present disclosure lies in shortening time required for judgment of presence or absence of collision in comparison to the case in which the technique of the present disclosure is not employed, even in the case in which the presence or absence of collision is judged using a three-dimensional model. Alternatively, an advantage of the present disclosure lies in avoidance of collision between the structures.

### SUMMARY

According to one aspect of the present disclosure, there is provided a collision judgment apparatus comprising: judgment means configured to judge presence or absence of overlap between a dynamic object having a position which changes in a sample chamber of a charged particle beam apparatus, and a static object having a position which does not change in the sample chamber, by collating point group information which represents, with a group of points, a three-dimensional shape of the dynamic object, and which includes position information of the dynamic object, and voxel group information which represents, with a group of voxels, a three-dimensional shape of the static object, which includes position information of the static object, and which is formed into a database; and output means configured to output a result of judgment of the judgment means, wherein a coordinate system including a three-dimensional orthogonal coordinate system formed from three coordinate axes which are orthogonal to each other is defined, and the judgment means is configured to judge the presence or absence of overlap between the dynamic object and the static object by collating, for each of the coordinate axes, voxel group information representing the static object which is present on a movement path of the dynamic object, and point group information representing the dynamic object.

The coordinate system may further include a tilt axis of the dynamic object, and the judgment means may be configured to judge the presence or absence of overlap between the dynamic object and the static object by collating, for each of the coordinate axes, voxel group information representing the static object which is present on a movement path of the dynamic object, and point group information representing the dynamic object, in a state in which the dynamic object is tilted about the tilt axis.

The coordinate system may further include a rotational axis of the dynamic object, point group information representing the dynamic object may be generated for each range of rotational angles which is predetermined, and the judgment means may be configured to judge the presence or absence of overlap between the dynamic object and the static object by collating point group information of the dynamic object according to a range of a rotational angle, and voxel group information representing the static object.

The judgment means may be configured to: judge the presence or absence of overlap between the dynamic object and the static object by collating, in an order for each of the coordinate axes, voxel group information representing the static object which is present on a movement path of the dynamic object, and point group information representing the dynamic object; and, when it is judged that the dynamic object and the static object overlap each other, change the order of coordinate axis for the collation, and judge the presence or absence of overlap between the dynamic object and the static object by collating, for each of the coordinate axes, voxel group information representing the static object which is present on a movement path of the dynamic object, and point group information representing the dynamic object.

Voxel group information for each state of the static object may be generated, and the judgment means may be further configured to judge the presence or absence of overlap between the dynamic object and the static object by collating voxel group information corresponding to a state of the static object, and point group information representing the dynamic object.

The static object may include a structure which reciprocates between a first position and a second position, and the state of the static object may be a state when the structure is at the first position, a state when the structure is at the second position, or a state when the structure is reciprocating between the first position and the second position.

The judgment means may be further configured to judge the presence or absence of overlap between the dynamic object and the static object by collating point group information representing the dynamic object according to a condition of observation by the charged particle beam apparatus, and voxel group information representing the static object.

The condition of observation may be a condition related to a voltage applied to a sample which is a target of observation.

The collision judgment apparatus may further comprise a user interface that receives input of a size of a sample mounted on the dynamic object, and the judgment means may be configured to judge the presence or absence of overlap between the dynamic object and the static object by collating point group information representing a group of points of the dynamic object reflecting the size received by the user interface, and voxel group information representing the static object.

The collision judgment apparatus may further comprise calculation means configured to calculate a height of a sample based on a tilt manipulation of the dynamic object on which the sample is mounted, and a movement manipulation of the dynamic object in a height direction, and the judgment means may be configured to judge the presence or absence of overlap between the dynamic object and the static object by collating point group information representing a group of points of the dynamic object reflecting a height calculated by the calculation means, and voxel group information representing the static object.

According to another aspect of the present disclosure, there is provided a computer-readable recording medium recording a program which, when executed, causes a computer to function as: judgment means configured to judge presence or absence of overlap between a dynamic object having a position which changes in a sample chamber of a charged particle beam apparatus, and a static object having a position which does not change in the sample chamber, by collating point group information which represents, with a group of points, a three-dimensional shape of the dynamic object, and which includes position information of the dynamic object, and voxel group information which represents, with a group of voxels, a three-dimensional shape of the static object, which includes position information of the static object, and which is formed into a database; and output means configured to output a result of judgment of the judgment means, wherein a coordinate system including a three-dimensional orthogonal coordinate system formed from three coordinate axes which are orthogonal to each other is defined, and the judgment means is configured to judge the presence or absence of overlap between the dynamic object and the static object by collating, for each of the coordinate axes, voxel group information representing the static object which is present on a movement path of the dynamic object, and point group information representing the dynamic object.

According to another aspect of the present disclosure, there is provided a method of judging collision, the method comprising: generating, based on a three-dimensional model representing a three-dimensional shape of a dynamic object having a position which changes in a sample chamber of a charged particle beam apparatus, point group information which represents, with a group of points, the three-dimensional shape of the dynamic object, and which includes position information of the dynamic object; generating, based on a three-dimensional model representing a three-dimensional shape of a static object having a position which does not change in the sample chamber, point group information which represents, with a group of points, the three-dimensional shape of the static object, and which includes position information of the static object; and generating, based on the point group information of the static object, voxel group information which represents, with a group of voxels, the three-dimensional shape of the static object, and which is formed into a database, wherein a coordinate system including a three-dimensional orthogonal coordinate system formed from three coordinate axes which are orthogonal to each other is defined, and the method further comprises judging presence or absence of overlap between the dynamic object and the static object by collating, for each of the coordinate axes, voxel group information representing the static object which is present on a movement path of the dynamic object, and point group information representing the dynamic object.

According to an aspect of the present disclosure, presence or absence of collision can be more accurately judged in comparison to the case in which the presence or absence of collision between structures is judged on a two-dimensional plane. Further, even when the presence or absence of collision is to be judged using a three-dimensional model, time required for the judgment of the presence or absence of collision can be shortened in comparison to the case in which the technique according to the present disclosure is not employed. Moreover, collision between the structures can be avoided in advance.

### BRIEF DESCRIPTION OF DRAWINGS

Embodiment(s) of the present disclosure will be described based on the following figures, wherein:
FIG. 1 is a block diagram showing a functional structure of a collision judgment apparatus according to an embodiment of the present disclosure;
FIG. 2 is a block diagram showing a structure of hardware of the collision judgment apparatus according to the embodiment of the present disclosure;
FIG. 3 is a diagram showing a three-dimensional model of an objective lens and a three-dimensional model of a sample holder;
FIG. 4 is a diagram showing a group of points for the objective lens, and a group of points for the sample holder;
FIG. 5 is a diagram showing a group of voxels for the objective lens;
FIG. 6 is a diagram showing voxel group information which is formed into a database;
FIG. 7 is a perspective diagram showing an actual objective leans and an actual sample holder;
FIG. 8 is a diagram showing a group of voxels for the objective lens and a group of points for the sample holder;
FIG. 9 is a diagram showing a three-dimensional model of a static object and a three-dimensional model of a dynamic object;
FIG. 10 is a diagram schematically showing a structure of the dynamic object;
FIG. 11 is a diagram showing a structure on a Y-Z plane:
FIG. 12 is a perspective diagram showing an example of the sample holder;
FIG. 13 is a diagram showing a screen which is an example of a user interface;
FIG. 14 is a diagram showing a screen which is an example of the user interface;
FIG. 15 is a perspective diagram showing an example of the sample holder;
FIG. 16 is a diagram showing the sample holder and a sample;
FIG. 17 is a diagram showing the sample holder and the sample;
FIG. 18 is a diagram showing the sample holder and the sample;
FIG. 19 is a diagram showing a screen;
FIG. 20 is a diagram showing a screen;
FIG. 21 is a diagram showing a three-dimensional model of the static object and a three-dimensional model of the dynamic object;
FIG. 22 is a diagram showing the three-dimensional model of the static object and the three-dimensional model of the dynamic object;
FIG. 23 is a diagram showing the three-dimensional model of the static object and the three-dimensional model of the dynamic object;
FIG. 24 is a diagram showing a group of points for the static object;
FIG. 25 is a diagram showing the structure viewed on an X-Z plane;
FIG. 26 is a diagram showing a movement path in the X-Z plane or a Y-Z plane;
FIG. 27 is a diagram showing the structure viewed on the Y-Z plane;
FIG. 28 is a diagram showing a movement path in the Y-Z plane;
FIG. 29 is a diagram showing a relationship between points and voxels;
FIG. 30 is a diagram showing a path of a tilt movement;
FIG. 31 is a diagram showing a path of a rotational movement;
FIG. 32 is a diagram showing a three-dimensional model and a group of points;
FIG. 33 is a diagram showing the group of points;
FIG. 34 is a diagram showing the sample holder;
FIG. 35 is a diagram showing the three-dimensional model;
FIG. 36 is a diagram for explaining a collision judgment method of related art;
FIG. 37 is a diagram for explaining the collision judgment method of related art; and
FIG. 38 is a diagram for explaining the collision judgment method of related art.

### DESCRIPTION OF EMBODIMENTS

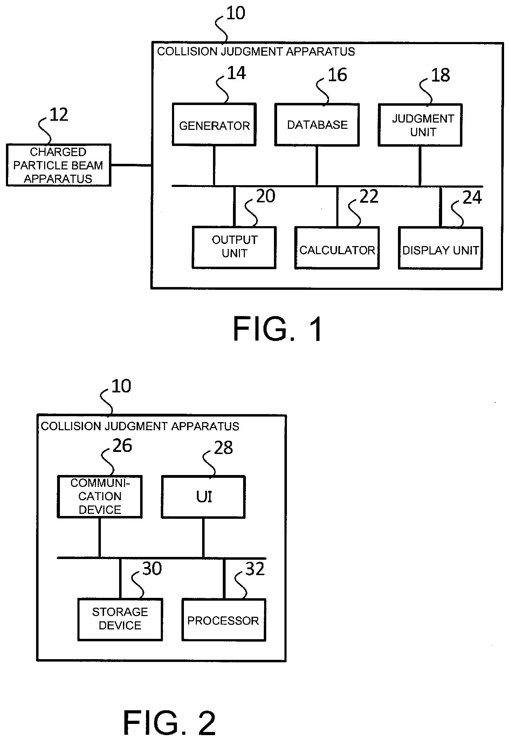

A collision judgment apparatus 10 according to an embodiment of the present disclosure will now be described with reference to FIG. 1. FIG. 1 is a block diagram showing functional structures of the collision judgment apparatus 10.

The collision judgment apparatus 10 judges presence or absence of collision between structures which are present in a sample chamber of a charged particle beam apparatus 12. The charged particle beam apparatus 12 is an electron microscope such as an SEM or TEM, an FIB apparatus, an AES apparatus, or the like. The collision judgment apparatus 10 may be equipped in the charged particle beam apparatus 12, or may be formed as an apparatus separate from the charged particle beam apparatus 12.

The collision judgment apparatus 10 acquires position information showing a position of each structure from the charged particle beam apparatus 12, and judges presence or absence of collision between the structures based on the position information of each of the structures.

In the present embodiment, each structure present in the sample chamber of the charged particle beam apparatus 12 is classified into a dynamic object or a static object, and the dynamic object and the static object are distinguished.

The dynamic object is a structure having a position which changes in the sample chamber. For example, the dynamic object may be a sample holder, a sample stage on which the sample holder is mounted, and a sample mounted on the sample holder.

The static object is a structure having a position which does not change in the sample chamber. For example, the static object may be a wall surface of the sample chamber, an objective lens, and a detector which reciprocates on a predetermined path.

Each of the structures in the sample chamber classified in advance into either the dynamic object or the static object. The structures described herein are only exemplary, and objects other than the structures exemplified herein may be classified into the dynamic object or the static object.

Position information indicating a position of the dynamic object, and position information indicating a position of the static object are output from the charged particle beam apparatus 12 to the collision judgment apparatus 10, and the collision judgment apparatus 10 judges the presence or absence of collision between the dynamic object and the static object based on the position information indicating the position of the dynamic object and the position information indicating the position of the static object. For example, when an amount of movement and a direction of movement of a dynamic object are designated by a user in the charged particle beam apparatus 12, and a command for movement is supplied, information showing the amount of movement and the direction of movement is output from the charged particle beam apparatus 12 to the collision judgment apparatus 10. The collision judgment apparatus 10 judges the presence or absence of collision between the dynamic object and the static object based on this information.

The collision judgment apparatus 10 includes, for example, a generator 14, a database 16, a judgment unit 18, an output unit 20, a calculator 22, and a display unit 24.

The generator 14 generates, based on a three-dimensional model representing a three-dimensional shape of a structure, point group information representing, with a group of points, the three-dimensional shape of the structure. For example, the three-dimensional model is generated in advance, and is input to the collision judgment apparatus 10. A size (for example, a height or a width) of the structure may be input by a user. In this case, the generator 14 generates a three-dimensional model and point group information according to the size which is input by the user. A user interface for inputting the size may be provided to the user.

The point group information is information representing the three-dimensional shape of the structure with a group of points (that is, a point group) distributed in a three-dimensional space, and includes position information indicating a position of the structure in the sample chamber. The position of the structure is a position in three-dimensional space. More specifically, the point group information includes position information indicating a position of each of the points representing the structure. For example, the generator 14 acquires the position information of the structure from the charged particle beam apparatus 12, and includes the position information in the point group information for the structure. The generator 14 generates point group information for each of the dynamic object and the static object.

The generator 14 also generates, based on the point group information of the static object, voxel group information representing the three-dimensional shape of the static object with a group of voxels. Specifically, the generator 14 defines a unit of the three-dimensional space divided in a lattice shape as a voxel, and links information indicating the presence of the static object (for example, a value of "1") to a voxel including a point representing the static object (that is, a voxel where the static object is present). The generator 14 links information indicating that the static object is not present (for example, a value of "0") to a voxel which does not include a point representing the static object (that is, a voxel in which the static object is not present). In this manner, the generator 14 represents the three-dimensional shape of the static object with information linked to each of the voxels distributed within the three-dimensional space (information indicating presence or absence of the static object). The generator 14 forms the information representing presence or absence of the static object into a database, and generates voxel group information representing the three-dimensional shape of the static object with a group of voxels. The voxel group information includes the position information of the static object in the sample chamber. More specifically, the voxel group information includes the position information indicating the position of each of the voxels representing the structure.

The database 16 stores the voxel group information of the static object, which is formed into the database.

The judgment unit 18 judges presence or absence of overlap between the dynamic object and the static object by collating the point group information representing the dynamic object and the voxel group information representing the static object. When the dynamic object and the static object overlap each other, the judgment unit 18 judges that the dynamic object and the static object collide with each other. When the dynamic object and the static object do not overlap each other, the judgment unit 18 judges that the dynamic object and the static object do not collide with each other.

Moreover, the judgment unit 18 may judge the presence or absence of overlap between the dynamic object and the static object by collating, for each of the coordinate axes, the voxel group information representing the static object which is present on a movement path of the dynamic object, and the point group information representing the dynamic object. For example, a coordinate system is defined which includes a three-dimensional orthogonal coordinate system formed from three coordinate axes which are orthogonal to each other, and the judgment unit 18 judges the presence or absence of overlap between the dynamic object and the static object for each of the coordinate axes. The coordinate axes may include a tilt axis and a rotational axis of the dynamic object.

Alternatively, point group information representing the dynamic object may be generated in advance for each predetermined range of rotational angles. In this case, the judgment unit 18 judges the presence or absence of overlap between the dynamic object and the static object by collating the point group information of the dynamic object according to a range of a rotational angle, and the voxel group information representing the static object. With this configuration, the time required for judgment of collision can be shortened in comparison to the case in which the point group information representing the rotated dynamic object is generated every time the dynamic object rotates, and the collision is then judged.

Alternatively, the voxel group information may be generated in advance for each state of the static object. In this case, the judgment unit 18 judges the presence or absence of overlap between the dynamic object and the static object by collating the voxel group information corresponding to the state of the static object, and the point group information representing the dynamic object. For example, when a state of the static object changes, voxel group information for each state is generated in advance, corresponding to the change. With this configuration, the time required for judgment of collision can be shortened in comparison to the case in which the voxel group information representing the static object corresponding to a state is generated every time there is a change in the state, and the collision is then judged.

The output unit 20 outputs information indicating a result of judgment of the judgment unit 18. The output unit 20 may cause information indicating the result of the judgment to be displayed on the display unit 24, may represent the result of the judgment with a sound and cause the sound to be generated from a speaker, may send the information to an external device (for example, a terminal apparatus of the user), or may cause the information to be printed on a medium such as paper. Further, the output unit 20 may cause the display unit 24 to display information indicating that the judgment unit 18 is currently judging, during the judgment by the judgment unit 18.

The calculator 22 calculates a height of the sample mounted in the sample chamber. Specifically, the calculator 22 calculates the height of the sample based on a tilt manipulation of the dynamic object and a movement manipulation in the height direction. Alternatively, the calculator 22 may be not included in the collision judgment apparatus 10.

The display unit 24 is a display such as a liquid crystal display or an EL display. The display unit 24 displays various information such as the information indicating the result of the judgment by the judgment unit 18. The display unit 24 may also function as an example of the user interface.

FIG. 2 shows a structure of the hardware of the collision judgment apparatus 10.

The collision judgment apparatus 10 includes a communication device 26, a UI 28, a storage device 30, and a processor 32.

The communication device 26 includes one or a plurality of communication interfaces having a communication chip, a communication circuit, or the like, and has a function to transmit information to other devices, and a function to receive information from other devices. The communication device 26 may have a wireless communication function such as a close-distance wireless communication or Wi-Fi (registered trademark), or a wired communication function.

The UI 28 is a user interface, and includes a display and an inputting device. The display is a liquid crystal display, an EL display, or the like. The inputting device is a keyboard, a mouse, an input key, a manipulation panel, or the like. The UI 28 may be an UI such as a touch panel, which has both functions of the display and the inputting device.

The storage device 30 is a device which forms one or a plurality of storage regions for storing data. The storage device 30 is, for example, a hard disk drive (HDD), a solid state drive (SSD), any of various memories (for example, a RAM, a DRAM, a ROM, or the like), other storage devices (for example, an optical disk or the like), or a combination of these. For example, the point group information and the voxel group information described above are stored in the storage device 30. Data representing a three-dimensional model of each structure may be stored in the storage device 30. In addition, the database 16 is constructed by the storage device 30. Alternatively, the point group information and the voxel group information described above may be stored in an external device other than the collision judgment apparatus 10 (for example, an external storage device and a device such as a server), and the database 16 may be constructed by an external device.

The processor 32 controls operations of various parts of the collision judgment apparatus 10. The processor 32 includes, for example, a CPU (Central Processing Unit), a GPU (Graphics Processing Unit), an ASIC (Application Specific Integrated Circuit), an FPGA (Field Programmable Gate Array), a DSP (Digital Signal Processor), other programmable logic devices, or an electronic circuit.

The functions of the collision judgment apparatus 10 shown in FIG. 1 are realized by the processor 32. When the functions are executed, the UI 28 and the storage device 30 may be utilized.

For example, the functions of the collision judgment apparatus 10 are realized by cooperation of a hardware resource and a software resource. For example, the functions are realized by the CPU forming the processor 32 reading and executing a program stored in the storage device 30. The program is stored in the storage device 30 via a recording medium such as a CD or a DVD, or via a communication path such as a network. As another example, the functions of the collision judgment apparatus 10 may be realized by a hardware resource such as an electronic circuit.

The embodiment will now be described with reference to a specific example.

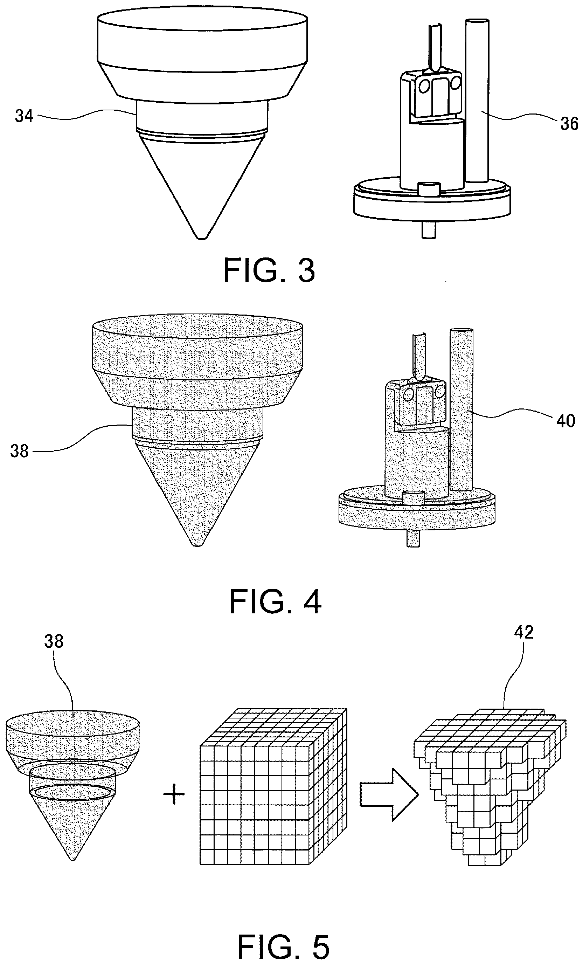

An example of the structure will now be described with reference to FIG. 3. FIG. 3 shows a three-dimensional model of an objective lens 34, and a three-dimensional model of a sample holder 36. The objective lens 34 and the sample holder 36 are examples of the structures which are present in the sample chamber of the charged particle beam apparatus 12. The three-dimensional model of the objective lens 34 is a model three-dimensionally representing the objective lens 34. The three-dimensional model of the sample holder 36 is a model three-dimensionally representing the sample holder 36. The three-dimensional models are generated in advance and input to the collision judgment apparatus 10. Alternatively, data of these three-dimensional models may be stored in the storage device 30.

The objective lens 34 is an example of the static object, and is a structure which is presumed to have a position which does not change in the sample chamber. The sample holder 36 is an example of the dynamic object, and is a structure which is presumed to have a position which changes in the sample chamber.

The generator 14 generates point group information representing the three-dimensional shape of the objective lens 34 with a group of points, based on the three-dimensional model of the objective lens 34. Similarly, the generator 14 generates point group information representing the three-dimensional shape of the sample holder 36 with a group of points, based on the three-dimensional model of the sample holder 36.

FIG. 4 shows examples of groups of points representing structures. A group of points 38 is a group of points representing the three-dimensional shape of the objective lens 34 with a group of points distributed in a three-dimensional space. A group of points 40 is a group of points representing the three-dimensional shape of the sample holder 36 with a group of points distributed in the three-dimensional space. The point group information indicating the group of points 38 and the point group information indicating the group of points 40 are stored in the storage device 30.

The point group information indicating the group of points 38 includes position information showing a position of each of the points included in the group of points 38 (a position of each point in the three-dimensional space). That is, the point group information indicating the group of points 38 includes position information indicating a position of each of the points representing the objective lens 34 in the sample chamber. For example, the position information indicating the position of the objective lens 34 in the sample chamber is output from the charged particle beam apparatus 12 to the collision judgment apparatus 10, and the generator 14 includes the position information in the point group information of the group of points 38.

The point group information indicating the group of points 40 includes position information indicating a position of each of the points included in the group of points 40 (a position of each point in the three-dimensional space). That is, the point group information indicating the group of points 40 includes position information indicating the position of each of the points representing the sample holder 36 in the sample chamber. For example, the position information indicating the position of the sample holder 36 in the sample chamber is output from the charged particle beam apparatus 12 to the collision judgment apparatus 10, and the generator 14 includes the position information in the point group information of the group of point 40.

The generator 14 further generates voxel group information representing the three-dimensional shape of the objective lens 34 with a group of voxels, based on the point group information indicating the group of points 38 of the objective lens 34, which is a static object. FIG. 5 shows a group of voxels 42 representing the objective lens 34.

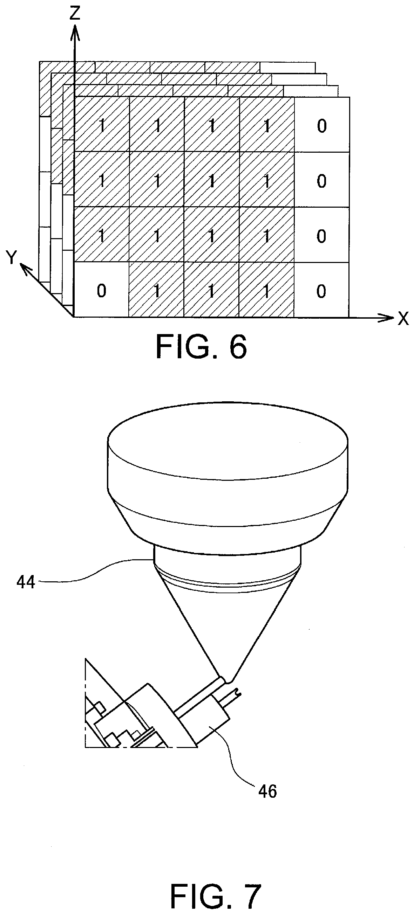

Next, the voxel group information of the objective lens 34 will be described in detail with reference to FIG. 6. FIG. 6 shows the voxel group information formed into a database. An X axis, a Y axis, and a Z axis which are orthogonal to each other are defined, and a plurality of voxels in a lattice shape are distributed in the three-dimensional space.

The generator 14 defines a unit of the three-dimensional space divided in the lattice shape as a voxel, and links information indicating presence or absence of the objective lens 34 to each voxel based on the point group information indicated by the group of points 38. A value of "1" in FIG. 6 is information indicating that the objective lens 34 is present, and a value of "0" is information indicating that the objective lens 34 is not present.

A voxel to which the value of "1" is linked is a voxel in which the objective lens 34 is present (that is, a voxel including a point included in the group of points 38). A voxel to which the value of "0" is linked is a voxel in which the objective lens 34 is not present (that is, a voxel with no point included in the group of points 38).

As shown in FIG. 6, the generator 14 links the value of "1" or the value of "0" to each voxel based on the point group information indicating the group of points 38, to generate voxel group information which represents the three-dimensional shape of the objective lens 34 with the information (the value of "1" or the value of "0") linked to each of the voxels distributed in the three-dimensional space. In this manner, the information indicating the presence or absence of the objective lens 34 is formed into a database. The voxel group information formed into the database is stored in the database 16. The voxel group information representing the three-dimensional shape of the objective lens 34 includes the position information indicating the positions of each of the voxels representing the objective lens 34.

In FIG. 5, in order to visually describe the three-dimensional shape of the objective lens 34 with the voxels, for convenience of description, only the voxels to which the value of "1" is linked are shown, and the voxels to which the value of "0" is linked are not shown. That is, while the group of voxels 42 shown in FIG. 5 is represented only with the voxels to which the value of "1" is linked, in the database representing the objective lens 34, the value of "1" is linked to the voxels in which the objective lens 34 is present, and the value of "0" is linked to the voxels in which the objective lens 34 is not present.

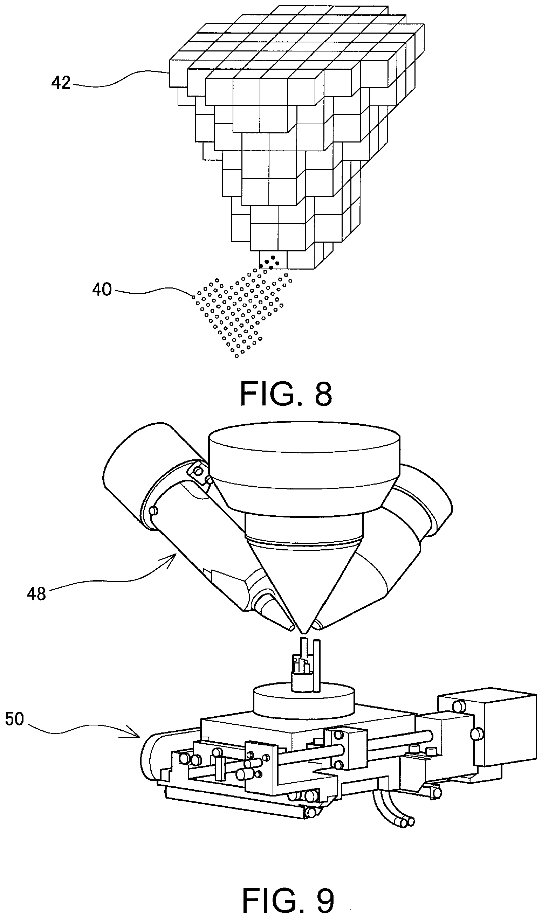

An overview of the judgment process by the judgment unit 18 will now be described with reference to FIGs. 7 and 8. FIG. 7 shows an actual objective lens 44 and an actual sample holder 46. FIG. 8 shows the group of voxels 42 representing the objective lens 44 and the group of points 40 representing the sample holder 46. For the convenience of description, FIG. 8 only shows voxels to which the value of "1" is linked.

The judgment unit 18 judges the presence or absence of overlap between the objective lens 44 and the sample holder 46 by collating the voxel group information formed in the databased and indicating the group of voxels 42 of the objective lens 44, and the point group information indicating the group of points 40 of the sample holder 46. For example, the position information indicating the position of the sample holder 46 is output from the charged particle beam apparatus 12 to the collision judgment apparatus 10, and the point group information including the position information is generated by the generator 14. The judgment unit 18 judges the presence or absence of overlap between the objective lens 44 and the sample holder 46 by collating the point group information generated in this manner, and the voxel group information representing the objective lens 44.

When at least one point included in the group of points 40 is present in the voxels included in the group of voxels 42, the judgment unit 18 judges that the objective lens 44 and the sample 46 overlap each other. In other words, the judgment unit 18 judges that the objective lens 44 and the sample holder 46 collide with each other.

When no point included in the group of points 40 is present in the voxels included in the group of voxels 42, the judgment unit 18 judges that the objective lens 44 and the sample holder 46 do not overlap each other. In other words, the judgment unit 18 judges that the objective lens 44 and the sample holder 46 do not collide with each other.

In the example configuration shown in FIG. 8, because a plurality of points included in the group of points 40 are present in the voxels included in the group of voxels 42, the judgment unit 18 judges that the objective lens 44 and the sample holder 46 overlap each other. In this case, the output unit 20 may cause the display unit 24 to display information indicating that the objective lens 44 and the sample holder 46 collide with each other (for example, alert information). When it is judged that the objective lens 44 and the sample holder 46 do not collide with each other, the output unit 20 may cause the display unit 24 to display information indicating that the objective lens 44 and the sample holder 46 do not collide with each other.

According to the present embodiment, because each of the point group information and the voxel group information is generated based on a three-dimensional model, it is possible to judge the presence or absence of collision between the dynamic object and the static object in consideration of not only the two-dimensional plane, but also the depth. As a result, the presence or absence of collision can be more accurately judged in comparison to the case in which the presence or absence of collision between the structures is judged on the two-dimensional plane.

Moreover, with the use of the three-dimensional model, it becomes possible to accurately judge the presence or absence of collision between structures having complicated shapes, to accurately judge the presence or absence of collision between structures which move in complicated movement paths, or to judge the presence or absence of collision in consideration of actual movements.

Furthermore, by judging the presence or absence of collision between the dynamic object and the static object before the dynamic object is actually moved, it becomes possible to avoid the collision in advance.

In the following, example configurations will be described.

### (First Example Configuration)

A first example configuration will now be described with reference to FIGs. 9 to 11.

FIG. 9 shows a three-dimensional model of a static object 48, and a three-dimensional model of a dynamic object 50. Here, as one example, the static object 48 is a structure such as an objective lens, and the dynamic object 50 is a structure such as a sample holder and a stage.

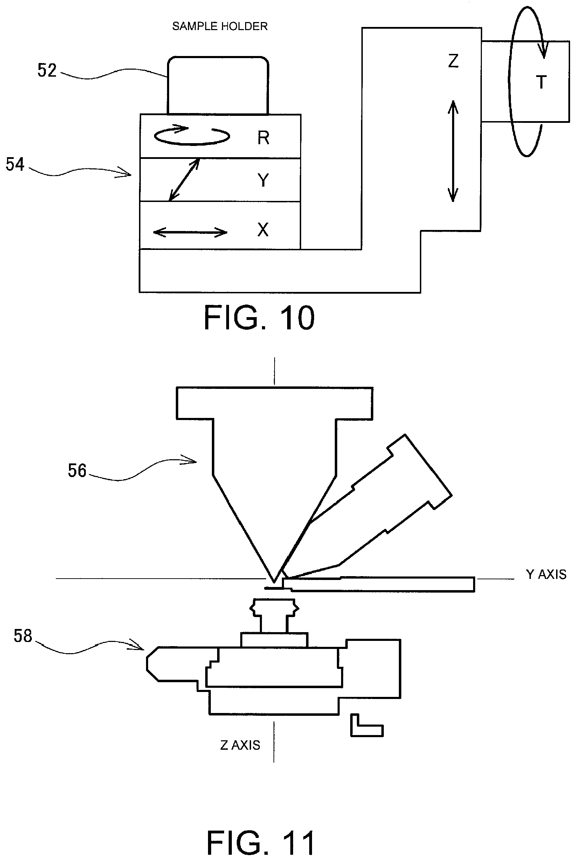

FIG. 10 schematically shows a structure of the dynamic object 50. The dynamic object 50 includes a sample holder 52 and a stage 54. An X axis, a Y axis, and a Z axis which are orthogonal to each other are defined, and the stage 54 is a structure movable along each of the X axis, the Y axis, and the Z axis. In addition, the stage 54 can be rotated with an R axis as a rotational axis, and can be tilted with a T axis as a tilt axis. Here, as one example, the X axis and the T axis coincide with each other.

For example, the stage 54 includes an X axis stage which is movable along the X axis, a Y axis stage which is movable along the Y axis, a Z axis stage which is movable along the Z axis, a T axis stage which can be tilted about the T axis, and an R axis stage which can be rotated about the R axis. The "X", "Y", "Z", "T", and "R" shown in FIG. 10 correspond to the respective axis stages.

When the X axis stage moves along the X axis, the sample holder 52 on the stage 54 also moves along the X axis. This is similarly applicable with respect to the Y axis and Z axis. When the T axis stage is tilted about the T axis, the sample holder 52 is also tilted about the T axis. When the R axis stage is rotated about the R axis, the sample holder 52 is also rotated about the R axis. In the example configuration shown in FIG. 10, because the R axis stage is provided on the Y axis stage, when the Y axis stage moves, the sample holder 52 on the stage 54 and the R axis stage move along the Y axis.

The generator 14 converts the three-dimensional model of the static object 48 into a group of points, to generate point group information of the static object 48. The generator 14 also converts the three-dimensional model of the dynamic object 50 into a group of points, to generate point group information of the dynamic object 50. The generator 14 further converts the group of points of the static object 48 into a group of voxels, to generate voxel group information of the static object 48. A three-dimensional model when the coordinates of all axes of the stage 54 (that is, the coordinates on the X axis, the Y axis, the Z axis, the T axis, and the R axis) are "0" is used as the three-dimensional model of the dynamic object 50. In addition, the X axis, the Y axis, and the Z axis of the three-dimensional space in which the coordinates of the groups of points are defined coincide with the X axis, the Y axis, and the Z axis when the stage 54 is not tilted (that is, when T=0).

The judgment unit 18 judges the presence or absence of overlap between the static object 48 and the dynamic object 50 by collating the voxel group information of the static object 48 and the point group information of the dynamic object 50. When it is judged that the static object 48 and the dynamic object 50 overlap each other, the position of the stage 54 at this point is judged as a position where collision between the static object 48 and the dynamic object 50 occurs. When it is judged that the static object 48 and the dynamic object 50 do not overlap each other, the position of the stage 54 at this point is judged as a position where collision between the static object 48 and the dynamic object 50 does not occur. In this manner, the presence or absence of collision between the static object 48 and the dynamic object 50 is judged.

When the presence or absence of collision is judged using the group of points and the group of voxels in three dimensions, the processing speed for the judgment is slower, and the required for the judgment is longer, in comparison to the case in which the presence or absence of collision is judged using a two-dimensional model.

In consideration of this, in the first example configuration, the judgment unit 18 first judges the presence or absence of collision between the static object 48 and the dynamic object 50 using the two-dimensional model. When it is judged in the judgment using the two-dimensional model that the static object 48 and the dynamic object 50 collide with each other, the judgment unit 18 then judges the presence or absence of collision between the static object 48 and the dynamic object 50 using the three-dimensional model, and according to the above-described embodiment.

The judgment of collision using the two-dimensional model will now be described with reference to FIG. 11. FIG. 11 shows a structure viewed in the Y-Z plane. A static object 56 is an object when the static object 48 is viewed in the Y-Z plane. A dynamic object 58 is an object when the dynamic object 50 is viewed in the Y-Z plane. For example, the generator 14 represents the two-dimensional static object 56 and the two-dimensional dynamic object 58 with polygons, and the judgment unit 18 judges whether or not the static object 56 and the dynamic object 58 overlap each other in the Y-Z plane.

When it is judged that the two-dimensional static object 56 and the two-dimensional dynamic object 58 overlap each other in the Y-Z plane, the judgment unit 18 judges the presence or absence of overlap between the static object 48 and the dynamic object 50 by collating the voxel group information of the three-dimensional static object 48 and the point group information of the three-dimensional dynamic object 50.

On the other hand, when it is judged that the two-dimensional static object 56 and the two-dimensional dynamic object 58 do not overlap each other in the Y-Z plane, the judgment unit 18 does not judge the presence or absence of overlap between the group of points and the group of voxels generated from the three-dimensional model.

In this manner, by first judging the presence or absence of collision using the two-dimensional model, an amount of information for the judgment can be reduced, and the time required for the judgment process can be shortened. In addition, by judging the presence or absence of collision through the judgment using the three-dimensional model after it is judged that the collision occurs through the judgment using the two-dimensional model, the presence or absence of collision can be accurately judged.

Depending on the type of the charged particle beam apparatus 12, arrangement of the axes may be different. For example, in the SEM, the Z axis stage is placed below the T axis stage. With the tilt of the dynamic object about the T axis, the movement direction of the Z axis stage does not change, but the position of the T axis stage changes according to the placement position of the Z axis stage. The generator 14 generates the point group information reflecting this change, and the judgment unit 18 judges the presence or absence of collision using this point group information.

### (Second Example Configuration)

In a second example configuration, a user interface for inputting a size of a sample mounted on the dynamic object is provided to the user, and the user inputs the size of the sample. The generator 14 generates point group information indicating a group of points of a dynamic object reflecting the input size. For example, the dynamic object is a sample holder, and the generator 14 generates point group information indicating a group of points of a dynamic object including the sample holder and a sample mounted on the sample holder. The judgment unit 18 judges the presence or absence of overlap between the dynamic object and the static object by collating the point group information indicating the group of points of the dynamic object reflecting the size of the sample, and voxel group information indicating a group of voxels of the static object.

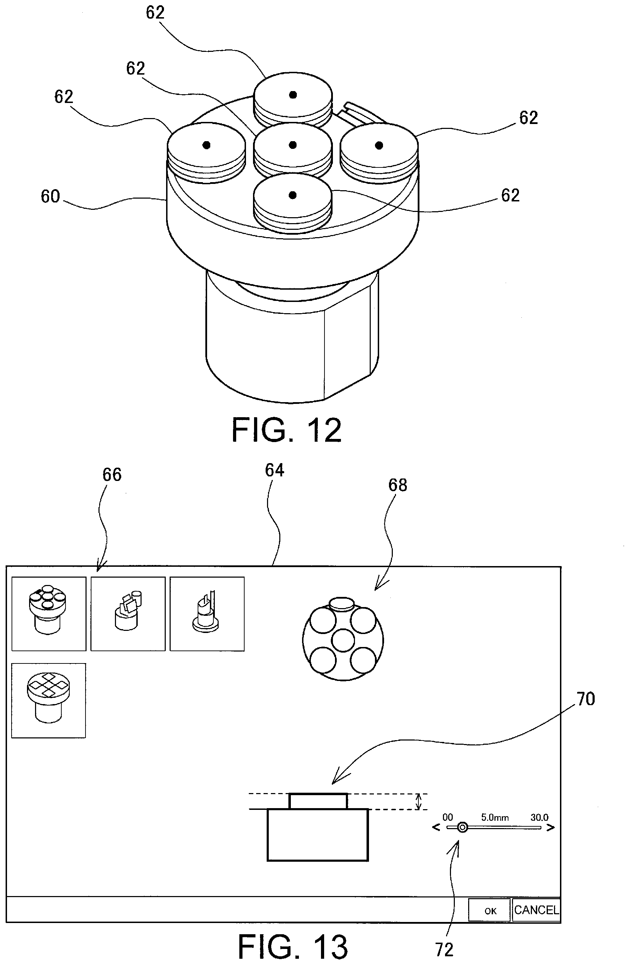

The second example configuration will now be described in detail with reference to FIGs. 12 to 15.

FIG. 12 shows a sample holder 60. The sample holder 60 is a sample holder on which a plurality of samples can be mounted. For example, a plurality of mounting parts 62 (five mounting parts 62 in the example structure shown in FIG. 12) are placed in the sample holder 60, and the samples are mounted on the mounting parts 62. For example, the sample is mounted at a center of a surface of each mounting part 62. The samples mounted on the mounting parts 62 may be samples having different sizes and different shapes, or samples having the same size and the same shape.

FIG. 13 shows a screen 64. The screen 64 is an example of a user interface for inputting the size of the sample, and is displayed on a display which is a part of the display unit 24. On the screen 64, a list 66 of candidates of the sample holder is displayed. In the example structure of FIG. 13, four sample holders are included in the list 66 as candidates, and an image representing each candidate is displayed on the screen 64. For example, when the user manipulates the UI 28 and commands display of the screen 64, the processor 32 causes the display to display the screen 64.

When the user selects a sample holder from the list 66, the processor 32 causes an image 68 representing the selected sample holder to be displayed on the screen 64.

In addition, an image 70 schematically representing the sample, and an input field 72 for inputting the size of the sample are displayed on the screen 64. Here, the size of the sample is a height of the sample, and the input field 72 is a field for inputting the height of the sample. Specifically, the input field 72 is a bar for adjusting the height of the sample, and the height of the sample is input by the user adjusting the bar.

The generator 14 generates point group information representing a group of points of a dynamic object reflecting the height which is input by the user. Here, as one example, the dynamic object includes the sample holder 60, the mounting part 62, and the sample, and the generator 14 generates point group information indicating a group of points of the dynamic object reflecting the height of the sample. For example, the generator 14 increases the height of the mounting part 62 by the height of the sample, and generates the point group information indicating the group of points of the dynamic object reflecting the increased height.

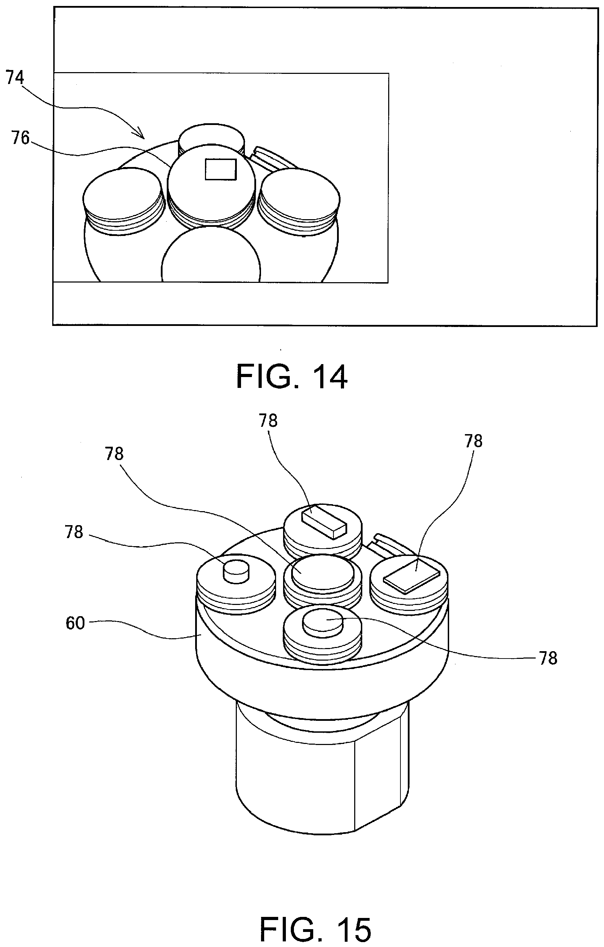

As shown in FIG. 14, the processor 32 may cause the display to display an image 74 representing the dynamic object reflecting the height of the sample which is input by the user. For example, the sample holder 60 and the mounting part 62 are represented in the image 74, and an image 76 representing an object having the input height is included in the image 74. The object corresponds to a portion of the mounting part 62 with the height increased by the input height. A shape of the object may be a shape such as a circular column, a rectangular parallelepiped, or the like.

As shown in FIG. 15, a plurality of samples 78 may be mounted on the sample holder 60. The sizes and the shapes of the samples 78 may differ from each other, or may be the same. In the example structure of FIG. 15, the sizes and the shapes of the samples 78 differ from each other.

For example, the user inputs, on the screen 64, a height of the sample 78 having the highest height among the plurality of sample 78. The generator 14 defines the input height as the height of the samples 78, and generates point group information indicating a group of points of the dynamic object reflecting the height.

As another example structure, the user may input the height of each sample 78 on the screen 64. In this case, the generator 14 generates point group information indicating a group of points of the dynamic object reflecting the heights of the samples 78.

The judgment unit 18 judges the presence or absence of overlap between the dynamic object and the static object by collating the point group information indicating the group of points of the dynamic object reflecting the height of the sample which is input by the user, and the voxel group information indicating the group of voxels of the static object. In addition, in the second example configuration also, similar to the first example configuration, the judgment unit 18 may first perform the judgment using the two-dimensional model, and then perform the judgment using the three-dimensional model.

According to the second example configuration, because the presence or absence of collision is judged using the point group information reflecting the height which is input by the user, it is possible to judge the presence or absence of collision in correspondence to arbitrary heights.

In the example described above, a case is described in which the sample is mounted on the sample holder, but alternatively, the process of the second example configuration may be executed when a component other than the sample is attached to the sample holder. In this manner, point group information indicating a group of points of a dynamic object reflecting the size of the attached component is generated, and the point group information and the voxel group information of the static object are collated with each other.

### (Third Example Configuration)

In a third example configuration, the calculator 22 is used, and a height of the sample is calculated by the calculator 22.

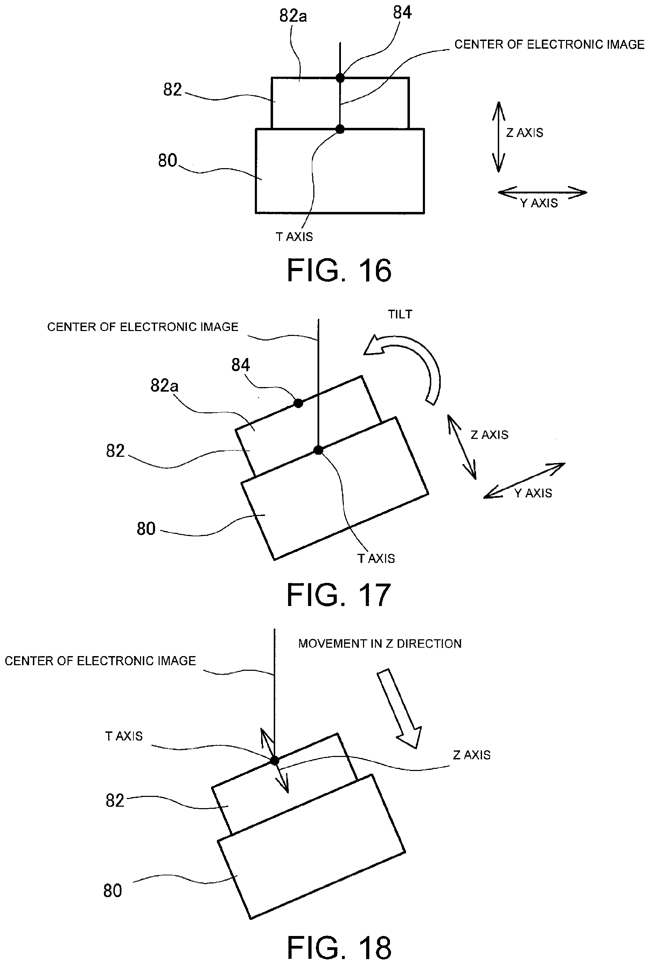

The third example configuration will now be described with reference to FIGs. 16 to 18. FIGs. 16 to 18 show a sample holder 80, a sample 82 mounted on the sample holder 80, and a target 84 present on a surface 82a of the sample 82. FIGs. 16 to 18 show the objects viewed in the Y-Z plane. In the third example configuration, while the sample holder 80 is tilted (that is, while the stage is tilted), the target on an electronic image is traced, to calculate the height of the sample 82. A specific procedure will now be described.
(1) First, in the charged particle beam apparatus 12, the stage on which the sample holder 80 is mounted is moved horizontally in a state of being not tilted.
(2) The user observes an electronic image generated by the imaging by the charged particle beam apparatus 12, and identifies the target 84 on the electronic image. Then, as shown in FIG. 16, the user moves the stage so that the target 84 is imaged at the center in the electronic image. With this process, the sample holder 80 and the sample 82 are moved. At this point, the stage is not tilted.
(3) Then, as shown in FIG. 17, the charged particle beam apparatus 12 tilts the stage about the T axis which is the tilt axis, to tilt the sample holder 80. An angle of tilt is, for example, a predetermined angle. Because the Y axis and the Z axis are defined with reference to the stage, with the tilt of the stage, the Y axis and the Z axis are also tilted with the same angle of tilt.
(4) Next, the user observes the electronic image, designates a position of the target 84 on the electronic image, and inputs information indicating the position into the charged particle beam apparatus 12. For example, the information indicating the position is input to the charged particle beam apparatus 12 via a UI.
(5) Then, as shown in FIG. 18, the charged particle beam apparatus 12 moves the stage along the Z axis so that the target 84 is imaged at the center on the electronic image, based on the position which is input by the user. With the movement of the stage, the sample holder 80 and the sample 82 are moved along the Z axis.
(6) The processes of (3) to (5) are repeated until the target 84 does not move on the electronic image when the sample holder 80 is tilted. For example, a state shown in FIG. 18 is the state in which the target 84 does not move on the electronic image when the sample holder 80 is tilted.
(7) Next, the calculator 22 identifies a Z coordinate of the surface 82a of the sample 82, and calculates the height of the sample 82 based on the Z coordinate.

In the following, a method of calculating the height of the sample 82 when the Z axis exists on the T axis will be described. As shown in FIG. 18, the state in which the target 84 does not move on the electronic image even when the sample holder 80 is tilted is a state in which the position of the target 84 coincides with the position of the T axis, and the surface 82a of the sample 82 and the T axis are in contact with each other. In this case, even when the sample holder 80 is tilted about the T axis, the target 84 does not move. The calculator 22 calculates the Z coordinate of the surface 82a when the surface 82a and the T axis are in contact with each other, when the height of the sample 82 is "0", and calculates a difference between the calculated Z coordinate and the Z coordinate calculated in (7), as the height of the sample 82. With this process, the height can be calculated more accurately.

When the height of the sample 82 is calculated in the manner described above, the generator 14 generates point group information indicating a group of points of the dynamic object reflecting the height. The judgment unit 18 judges the presence or absence of overlap between the dynamic object and the static object by collating the point group information indicating the group of points of the dynamic object reflecting the height, and the voxel group information indicating the group of voxels of the static object.

Alternatively, the user may designate the target 84, and the calculator 22 may apply pattern matching to the target 84 shown in the electronic image, to trace the position of the target 84 after the tilting manipulation.

### (Fourth Example Configuration)

In a fourth example configuration, the generator 14 generates point group information indicating a group of points of the dynamic object according to a condition of observation by the charged particle beam apparatus 12. The judgment unit 18 judges the presence or absence of overlap between the dynamic object and the static object by collating the point group information according to the observation condition, and the voxel group information indicating the group of voxels of the static object.

For example, the condition of observation is a condition related to a voltage applied to the sample which is a target of observation. When the sample and the objective lens become close to each other while a voltage is applied to the sample, electrical discharge may occur. In order to avoid this, the generator 14 sets a discharge risk region corresponding to the size of the voltage for the dynamic object, the static object, or both the dynamic object and the static object. That is, the generator 14 may set the discharge risk region covering the three-dimensional model of the dynamic object including the sample holder and the sample, may set the discharge risk region covering the three-dimensional model of the static object, or may set the discharge risk region covering the three-dimensional models of the dynamic object and the static object. The object for which the discharge risk region is set may be set by the user, or may be set in advance.

Here, as one example, the generator 14 sets the discharge risk region corresponding to the size of the voltage covering the three-dimensional model of the dynamic object including the sample holder and the sample. Alternatively, the generator 14 may set the discharge risk region covering the three-dimensional model of the static object including the objective lens, or may set the discharge risk region for both the dynamic object and the static object. A region where the electrical discharge may possibly occur is set as the discharge risk region. The generator 14 generates a three-dimensional model of the dynamic object including the sample holder, the sample, and the discharge risk region. For example, the generator 14 sets the discharge risk region for the original three-dimensional models representing the sample holder and the sample, to generate the three-dimensional model including the sample holder, the sample, and the discharge risk region.

The generator 14 generates the three-dimensional model of the dynamic object while increasing the size of the discharge risk region as the voltage becomes higher. For example, the generator 14 sets a size of the discharge risk region larger when the voltage is 5 kV in comparison to the size of the discharge risk region when the voltage is 2 kV, and generates the three-dimensional model of the dynamic object. Alternatively, the generator 14 may change a shape of the discharge risk region according to the size of the voltage.

The generator 14 generates point group information indicating, with a group of points, the dynamic object including the sample holder, the sample, and the discharge risk region, based on the three-dimensional model including the sample holder, the sample, and the discharge risk region. That is, the discharge risk region is treated as a dynamic object.

The judgment unit 18 judges the presence or absence of overlap between the dynamic object and the static object by collating the point group information indicating, with the group of points, the dynamic object including the sample holder, the sample, and the discharge risk region, and the voxel group information indicating the group of voxels of the static object.

By setting the discharge risk region as described, the occurrence of the electrical discharge can be prevented even when the observation is performed under the observation condition in which the electrical discharge may possibly occur.

### (Fifth Example Configuration)

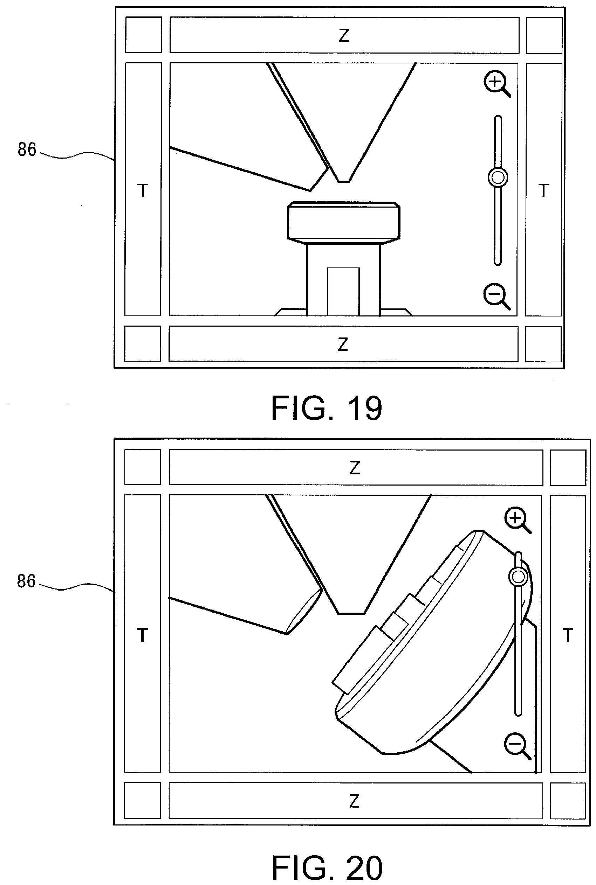

In a fifth example configuration, a scene in the sample chamber of the charged particle beam apparatus 12 is displayed as a three-dimensional model. The fifth example configuration will now be described with reference to FIGs. 19 and 20. FIGs. 19 and 20 show a screen 86.

The screen 86 is displayed on the display included in the display unit 24. The processor 32 generates a three-dimensional model representing the structure which is present in the sample chamber, and displays the three-dimensional model on the screen 86. For example, the objective lens, the sample holder, and the sample are structures present in the sample chamber, and a three-dimensional model representing these structures is generated, and displayed on the screen 86.

FIG. 19 shows the three-dimensional model in a zoomed-out state, and FIG. 20 shows the three-dimensional model in a zoomed-in state. For example, a bar for commanding enlarged display or reduced display is displayed on the screen 86, and the user can command the zooming-in or the zooming-out through manipulation of the bar.

By displaying the three-dimensional model representing the structures present in the sample chamber, the user can check a positional relationship of the structures, or the like. For example, the user can check the positional relationship between the objective lens and the surface of the sample.

Alternatively, a three-dimensional model representing a structure such as a detector may be generated and displayed. In this case, the user can check the positional relationship between the detector and the surface of the sample.

### (Sixth Example Configuration)

In a sixth example configuration, a group of voxels are generated in advance for each state of the static object, and voxel group information is generated in advance for each state of the static object and stored in the database 16. The judgment unit 18 reads voxel group information corresponding to the state of the static object from the database 16, and judges the presence or absence of overlap between the dynamic object and the static object by collating the voxel group corresponding to the state of the static object, and the point group information representing the dynamic object with the group of points.

Specifically, the dynamic object includes a structure which can reciprocate along a trajectory which is determined in advance. While the structure is a reciprocating object, because the structure is an object which moves on a trajectory which is determined in advance, the structure may be assumed to be a static object which is present on the trajectory.

For example, the structure is an object which reciprocates between a first position and a second position. The state of the static object is a state in which the structure is at the first position (hereinafter referred to as a "first state"), a state in which the structure is at the second position (hereinafter referred to as a "second state"), or a state in which the structure is reciprocating between the first position and the second position (hereinafter referred to as a "third state"). For example, one of the first position and the second position corresponds to a start position of the reciprocating movement, and the other of the first position and the second position corresponds to a completion position of the reciprocating movement.

The generator 14 generates in advance point group information representing, with a group of points, the static object when the structure is at the first position, based on a three-dimensional model (hereinafter referred to as a "first three-dimensional model") representing the static object when the structure is at the first position, and generates in advance voxel group information representing, with a group of voxels, the static object when the structure is at the first position, based on the point group information. In the following, the group of voxels representing the static object when the structure is at the first position will be referred to as a "first group of voxels", and the voxel group information representing the first group of voxels will be referred to as "first voxel group information".

The generator 14 also generates in advance point group information representing, with a group of points, the static object when the structure is at the second position, based on a three-dimensional model (hereinafter referred to as a "second three-dimensional model") representing the static object when the structure is at the second position, and generates in advance voxel group information representing, with a group of voxels, the static object when the structure is at the second position, based on the point group information. In the following, the group of voxels representing the static object when the structure is at the second position will be referred to as a "second group of voxels", and the voxel group information representing the second group of voxels will be referred to as "second voxel group information".

The generator 14 further generates in advance point group information representing, with a group of points, the static object when the structure is reciprocating between the first position and the second position, based on a three-dimensional model (hereinafter referred to as a "third three-dimensional model") representing the static object when the structure is reciprocating between the first position and the second position, and generates in advance voxel group information representing, with a group of voxels, the static object when the structure is reciprocating between the first position and the second position, based on the point group information. In the following, the group of voxels representing the static object when the structure is reciprocating between the first position and the second position will be referred to as a "third group of voxels", and the voxel group information representing the third group of voxels will be referred to as "third voxel group information".

The third three-dimensional model is a three-dimensional model which represents the trajectory of movement of the structure. Therefore, the third group of voxels is a group of voxels representing the trajectory of movement of the structure. That is, the third three-dimensional model is a three-dimensional model which represents the trajectory of movement of the structure when the structure moves between the first position and the second position, and the third group of voxels is a group of voxels representing the trajectory of movement of the structure when the structure moves between the first position and the second position.

The first voxel group information, the second voxel group information, and the third voxel group information are generated in advance, and stored in the database 16.

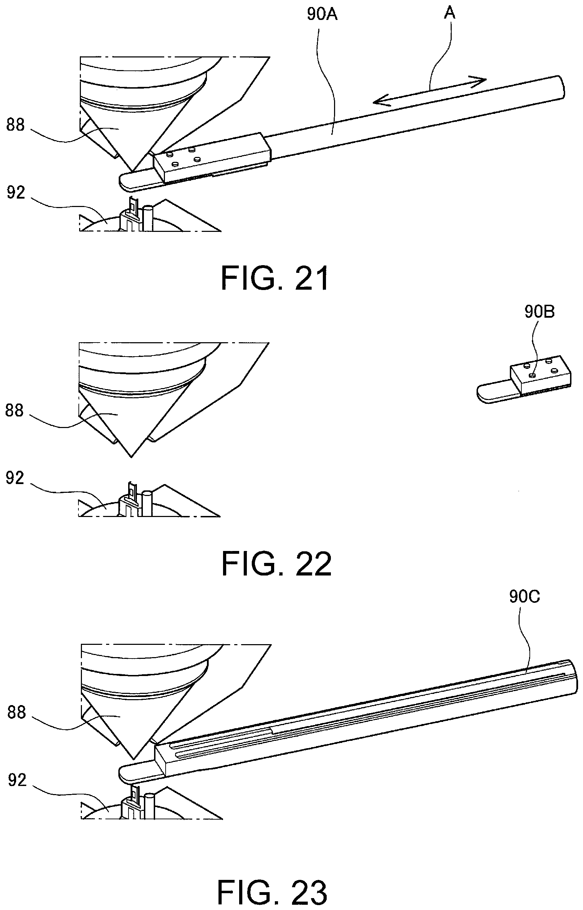

The sixth example configuration will now be described with reference to FIGs. 21 to 23. FIGs. 21 to 23 show a three-dimensional model of the static object and a three-dimensional model of the dynamic object.

FIGs. 21 to 23 show a three-dimensional model of the objective lens and a three-dimensional model of the detector as the three-dimensional models of the static objects, and a three-dimensional model of the sample holder as the three-dimensional model of the dynamic object.

A three-dimensional model 88 is the three-dimensional model of the objective lens, three-dimensional models 90A, 90B, and 90C are three-dimensional models of the detector, and a three-dimensional model 92 is the three-dimensional model of the sample holder.

The detector is an example of a structure which can reciprocate along a trajectory which is determined in advance. More specifically, the detector can reciprocate along a direction indicated by an arrow A in FIG. 21. That is, the trajectory along the direction indicated by the arrow A is determined, and the detector can reciprocate on the trajectory.

The three-dimensional model 90A shown in FIG. 21 is a three-dimensional model representing the detector which is present at the first position. The three-dimensional models 88 and 90A are three-dimensional models representing the static objects (that is, the objective lens and the detector) when the detector is at the first position. The state of the static object when the detector is at the first position is a state in which the detector is inserted between the objective lens and the sample holder (IN-state). The three-dimensional models 88 and 90A shown in FIG. 21 correspond to examples of the first three-dimensional model. The generator 14 generates in advance point group information representing, with a group of points, the static object when the detector is at the first position, based on the three-dimensional models 88 and 90A shown in FIG. 21, and generates in advance fist voxel group information representing, with a group of voxels (first group of voxels), the static object when the detector is at the first position, based on the point group information. The first voxel group information is linked to the information indicating the IN-state (that is, information indicating the first position), and is stored in the database 16.

The three-dimensional model 90B shown in FIG. 22 is a three-dimensional model representing the detector which is present at the second position. The three-dimensional models 88 and 90B are three-dimensional models representing the static objects (that is, the objective lens and the detector) when the detector is at the second position. The state of the static object when the detector is at the second position is a state in which the detector is withdrawn from the region between the objective lens and the sample holder to an external region (OUT-state). The three-dimensional models 88 and 90B shown in FIG. 22 correspond to examples of the second three-dimensional model. The generator 14 generates in advance point group information representing, with a group of points, the static object when the detector is at the second position, based on the three-dimensional models 88 and 90B shown in FIG. 22, and generates in advance second voxel group information representing, with a group of voxels (second group of voxels), the static object when the detector is at the second position, based on the point group information. The second voxel group information is linked to the information indicating the OUT-state (that is, information indicating the second position), and is stored in the database 16.

The three-dimensional model 90C shown in FIG. 23 is a three-dimensional model representing a state in which the detector is reciprocating between the first position and the second position. That is, the three-dimensional model 90C is a three-dimensional model representing the trajectory when the detector is reciprocating (that is, a three-dimensional model representing a path of reciprocating movement of the detector). The three-dimensional model 90C also represents the trajectory or the like of a reciprocating movement of a protruding structure (for example, a screw or the like) included in the detector. The state of the static objects (that is, the objective lens and the detector) in this case is an IN-OUT state; that is, a state in which the state of the detector is switched from the IN-state to the OUT-state, or from the OUT-state to the IN-state. The three-dimensional models 88 and 90C shown in FIG. 23 correspond to examples of the third three-dimensional model. The generator 14 generates in advance point group information representing, with a group of points, the static object when the detector is reciprocating between the first position and the second position, based on the three-dimensional models 88 and 90C shown in FIG. 23, and generates third voxel group information representing, with a group of voxels (third group of voxels), the static object when the detector reciprocates between the first position and the second position, based on the point group information. The third voxel group information is linked to information indicating the IN-OUT state, and is stored in the database 16.

As described, the voxel group information for each state of the static object is generated in advance, and is stored in the database 16. That is, the voxel group information when the static object is in the IN-state, the voxel group information when the static object is in the OUT-state, and the voxel group information when the static object is in the IN-OUT state are stored in the database 16 in advance.

The judgment unit 18 judges the presence or absence of overlap between the dynamic object and the static object by collating the voxel group information corresponding to the state of the static object, and the point group information representing the dynamic object.

For example, at a phase before analysis or the like, when the stage (stage on which the sample holder is mounted) is to be moved when the state of the detector is the OUT-state, the judgment unit 18 judges the presence or absence of overlap between the dynamic object and the static object by collating the voxel group information when the state of the static object is the OUT-state, and the point group information of the dynamic object. In this process, the voxel group information when the state of the static object is the IN-state, and the voxel group information when the state of the static object is the IN-OUT state, are not used.

When the state of the detector switches from the OUT-state to the IN-state according to the timing of the analysis or the like, the judgment unit 18 judges the presence or absence of overlap between the dynamic object and the static object by collating the voxel group information when the state of the static object is the IN-OUT state, and the point group information of the dynamic object. In this process, the voxel group information when the state of the static object is the IN-state, and the voxel group information when the state of the static object is the OUT-state, are not used. When it is judged that the dynamic object and the static object overlap each other, the detector is not inserted between the objective lens and the sample holder. When it is not judged that the dynamic object and the static object overlap each other, the detector is inserted between the objective lens and the sample holder.

When the stage is to be moved when the state of the detector is the IN-state, the judgment unit 18 judges the presence or absence of overlap between the dynamic object and the static object by collating the voxel group information when the state of the static object is the IN-state, and the point group information of the dynamic object. In this process, the voxel group information when the state of the static object is the OUT-state, and the voxel group information when the state of the static object is the IN-OUT state, are not used.

At a phase after the analysis or the like, when the state of the detector is switched from the IN-state to the OUT-stage, the judgment unit 18 judges the presence or absence of overlap between the dynamic object and the static object by collating the voxel group information when the state of the static object is the IN-OUT state, and the point group information of the dynamic object.

As described, in the sixth example configuration, the voxel group information for each state of the dynamic object is generated in advance, and the voxel group information corresponding to the state of the static object and the point group information of the dynamic object are collated with each other. In this manner, the time required for the judgment of overlap can be shortened in comparison to the case in which the voxel group information corresponding to the state of the static object is generated every time of collation.

For example, as a comparative example configuration, there may be considered a configuration in which, when the detector moves, and the state of the detector is switched from the IN-state to the OUT-state or from the OUT-state to the IN-state, voxel group information for each position of the detector which is moving is generated, and the voxel group information corresponding to the position of the detector and the point group information of the dynamic object are collated. In this case, it is necessary to generate the voxel group information for each position of the detector while the detector is moving. However, if the voxel group information for each position of the detector is generated every time, time is required for generation, and the time required for judgment of overlap is correspondingly elongated. In the contrary, according to the sixth example configuration, because the voxel group information when the state of the static object is the IN-OUT state is generated in advance, the time required for the judgment can be shortened in comparison to the case in which the voxel group information is generated every time during the movement of the detector. The group of voxels when the state of the static object is the IN-OUT state includes a group of voxels representing the trajectory of movement of the detector; that is, the path of movement of the detector. Because of this, the presence or absence of collision when the detector is reciprocating can be judged using the voxel group information when the state of the static object is the IN-OUT state.

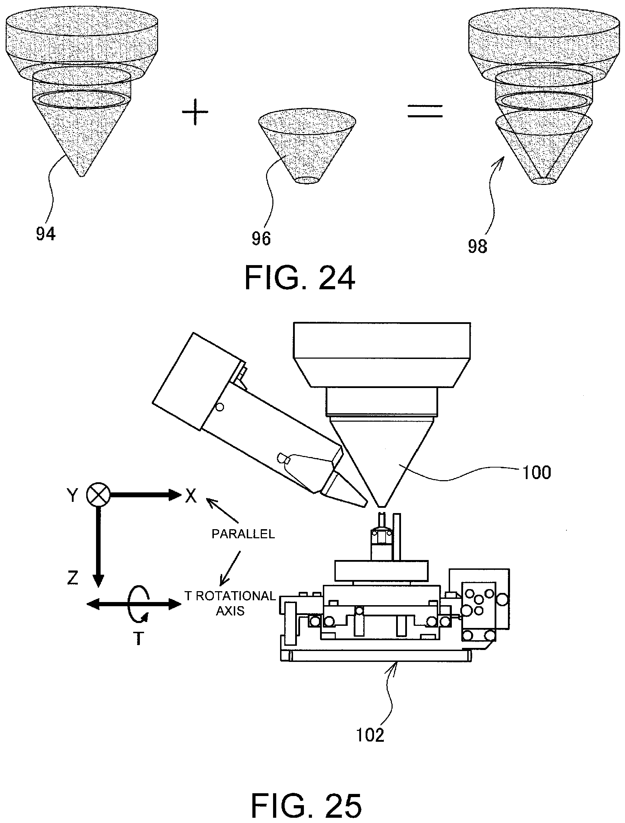

An alternative configuration of the sixth example configuration will now be described with reference to FIG. 24. FIG. 24 shows a group of points 94 representing the objective lens in a normal state, and a group of points 96 representing an approach prohibition region.

Depending on the observation mode, it may be desired to move the dynamic object closer to the objective lens than in the normal state. In this case, the generator 14 combines the group of points 94 representing the objective lens in the normal state, and the group of points 96 representing the approach prohibition region, to generate a combined group of points 98 representing the objective lens and the approach prohibition region. The approach prohibition region may be set in advance, or may be set by the user. The generator 14 generates voxel group information based on the combined group of points 98.

When the observation mode which requires the approach prohibition region is executed, the judgment unit 18 judges the presence or absence of overlap between the dynamic object and the static object by collating the voxel group information generated based on the combined group of points 98, and the point group information of the dynamic object.

### (Seventh Example Configuration)

In a seventh example configuration, the judgment unit 18 judges the presence or absence of overlap between the dynamic object and the static object by collating voxel group information representing the static object which is present on a movement path of the dynamic object, and the point group information of the dynamic object.

For example, a coordinate system including a three-dimensional orthogonal coordinate system formed from three coordinate axes which are orthogonal to each other is defined. The judgment unit 18 judges the presence or absence of overlap between the dynamic object and the static object by collating, for each of the coordinate axes, the voxel group information representing the static object which is present on the movement path of the dynamic object, and the point group information representing the dynamic object.

The above-described coordinate system further includes a tilt axis of the dynamic object. When the dynamic object is tilted about the tilt axis, the judgment unit 18 judges the presence or absence of overlap between the dynamic object and the static object by collating, for each of the coordinate axes, the voxel group information representing the static object which is present on the movement path of the dynamic object in the tilted state, and the point group information representing the dynamic object.

The seventh example configuration will now be described with reference to FIGs. 25 to 30. FIG. 25 shows a static object 100 and a dynamic object 102. The static object 100 includes, for example, an objective lens. The dynamic object 102 includes, for example, a stage, a sample holder mounted on the stage, and a sample mounted on the sample holder.

As described with reference to FIG. 10, the X axis, the Y axis, and the Z axis which are orthogonal to each other are defined, and the stage is a structure which is movable along each of the X axis, the Y axis, and the Z axis. The stage can be rotated with the R axis as the rotational axis, and can be tilted with the T axis as the tilt axis. Here, as one example, the X axis and the T axis coincide with each other. For example, the stage includes the X axis stage, the Y axis stage, the Z axis stage, the T axis stage, and the R axis stage. FIG. 25 shows the objects viewed in an X-Z plane.

In judging the overlap between the dynamic object and the static object, a configuration may be considered in which the group of voxels are viewed on a plane. This plane is, for example, the X-Z plane or the Y-Z plane. When the group of voxels are viewed on the plane, the group of voxels may be treated as a group of squares. The judgment unit 18 judges, for each of the axes of the X axis, the Y axis, the Z axis, and the T axis, whether or not a voxel to which the value of "1" is linked is present on the movement path of the dynamic object. When there is a voxel to which the value of "1" is linked on the movement path of the dynamic object, the judgment unit 18 judges that the dynamic object and the static object overlap each other at a position of the voxel to which the value of "1" is linked. When there is a voxel to which the value of "0" is linked on the movement path of the dynamic object, the judgment unit 18 judges that the dynamic object and the static object do not overlap each other at a position of the voxel to which the value of "0" is linked. The judgment unit 18 judges the presence or absence of overlap for each of the coordinate axes.

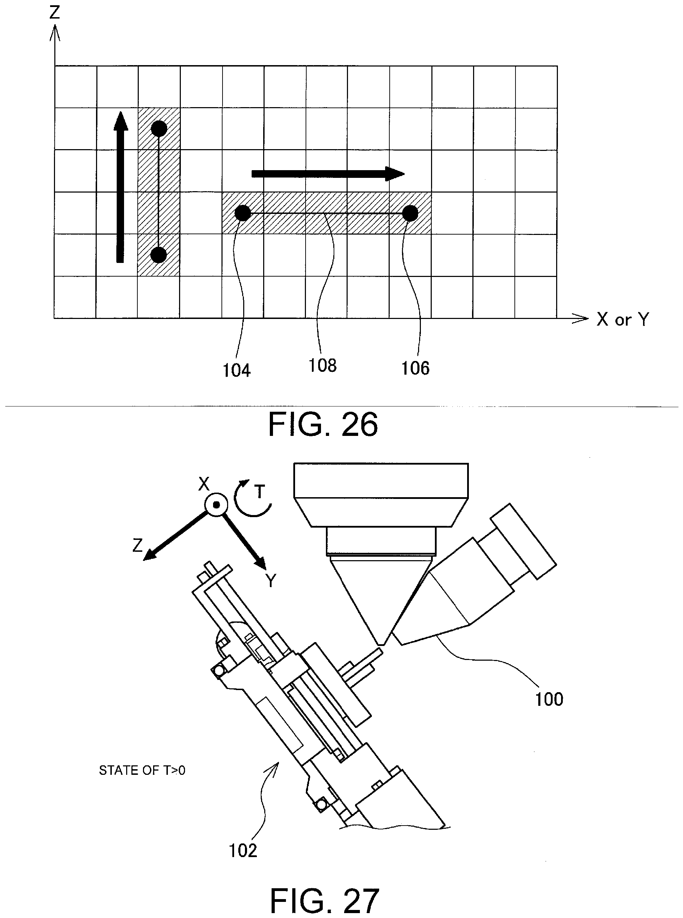

With reference to FIG. 26, a case in which the dynamic object is not rotated about the T axis (that is, when the tile angle is 0°) will be described. FIG. 26 shows the X-Z plane or the Y-Z plane. Here, movement in the X-Z plane will be described. In FIG. 26, the voxel is represented as cells of a two-dimensional square shape.

Movement directions of the X axis stage, the Y axis stage, and the Z axis stage respectively coincide with the X axis, the Y axis, and the Z axis defining the three-dimensional coordinate system. Thus, the judgment unit 18 can calculate a coordinate of a target position by calculating a coordinate indicating a current position of the group of points representing the dynamic object 102, and adding an amount of movement of the dynamic object 102 to the coordinate. For example, when an amount of movement and a direction of movement of the dynamic object 102 are designated and movement is commanded in the charged particle beam apparatus 12, information indicating the amount of movement and the direction of movement is output from the charged particle beam apparatus 12 to the collision judgment apparatus 10. The judgment unit 18 calculates the coordinate of the target position based on this information.

For example, when the movement path from the current position to the target position is viewed on the X-Z plane, the movement path along the X axis and the movement path along the Z axis are respectively represented as line segments connecting two points. For example, the movement path along the X axis is shown as a movement path from a current position 104 to a target position 106, and, when viewed on the X-Z plane, the movement path is represented as a line segment 108 connecting two points. When a voxel to which the value of "1" is linked (a cell represented with a two-dimensional square shape in FIG. 26) is present on the line segment 108, the judgment unit 18 judges that the dynamic object 102 and the static object 100 overlap each other when the dynamic object 102 moves along the X axis in the X-Z plane. When no voxel to which the value of "1" is linked is present on the line segment 108, the judgment unit 18 judges that the dynamic object 102 and the static object 100 do not overlap each other when the dynamic object 102 moves along the X axis in the X-Z plane. Similarly, for the movement along the Z axis, the presence or absence of overlap is judged. In addition, the presence or absence of overlap in the Y-Z plane is similarly judged.

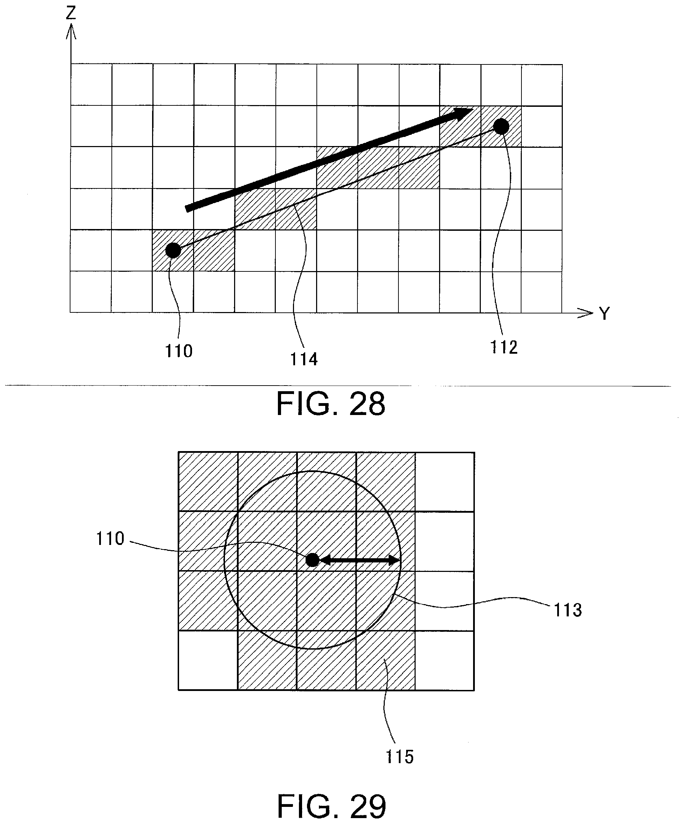

With reference to FIGs. 27 and 28, a case in which the dynamic object 102 is tilted about the T axis (that is, when the tilt angle > 0) will be described. FIG. 27 shows the dynamic object 102 in the tilted state. FIG. 28 shows the Y-Z plane. FIG. 28 shows the voxels as cells of a two-dimensional square shape.

Because the movement direction of the X axis stage and the T axis are parallel with each other, the tilt about the T axis does not affect the movement direction of the X axis stage. Thus, the judgment of the presence or absence of overlap on the X axis is realized with the same method as the judgment when the dynamic object 102 is not tilted about the T axis. On the other hand, the movement directions on the axes of the Y axis, the Z axis, and the T axis are tilted according to the tilt of the dynamic object 102 about the T axis.

The movement direction of each of the Y axis stage and the Z axis stage changes according to the tilt of the dynamic object 102 about the T axis, but neither axis stage moves in the movement direction of the X axis stage. Because of this, the presence or absence of overlap on each of the Y axis and the Z axis can be judged by checking voxels on a slanted line in the Y-Z plane, similar to the case when the dynamic object 102 is not tilted about the T axis.

The judgment unit 18 draws an approximating straight line assuming the voxel to be a pixel on the Y-Z plane, and checks whether the value linked to the voxel on the slanted line is "1" or "0". In FIG. 28, the movement path of the dynamic object in the Y-Z plane is shown as a movement path from a current position 110 to a target position 112. When viewed in the Y-Z plane, the movement path is represented as a line segment 114 connecting two points.

When a voxel (a cell of a square shape in FIG. 28) to which the value of "1" is linked is present on the line segment 114, the judgment unit 18 judges that the dynamic object 102 and the static object 100 overlap each other when the dynamic object 102 moves in the Y-Z plane. When no voxel to which the value of "1" is linked is present on the line segment 114, the judgment unit 18 judges that the dynamic object 102 and the static object 100 do not overlap each other when the dynamic object 102 moves in the Y-Z plane.

Strictly speaking, when the approximating straight line is used, an error may be caused. However, as shown in FIG. 29, by treating each point 110 included in the group of points as a sphere 113 when the group of points are converted to the group of voxels, it is possible to expand a region 115 where the object is present. For example, an inside of the sphere 113 and a portion overlapping a surface of the sphere 113 are included in the region 115 where the object is present. Through this expansion, the error when the voxels on the line are checked can be ignored. With this process, the presence or absence of overlap can be judged without checking all voxels present on the line. As a result, the time required for the judgment can be shortened.

Tilt movement about the T axis will now be described. Because the X axis stage and the T axis are parallel with each other, the tilt movement about the T axis does not affect the movement direction of the X axis stage. Because of this, the judgment unit 18 can calculate the coordinate of the target position by calculating the coordinate of the current position of the dynamic object 102, and then rotating the dynamic object 102 by the amount of movement about the T axis in the Y-Z plane.

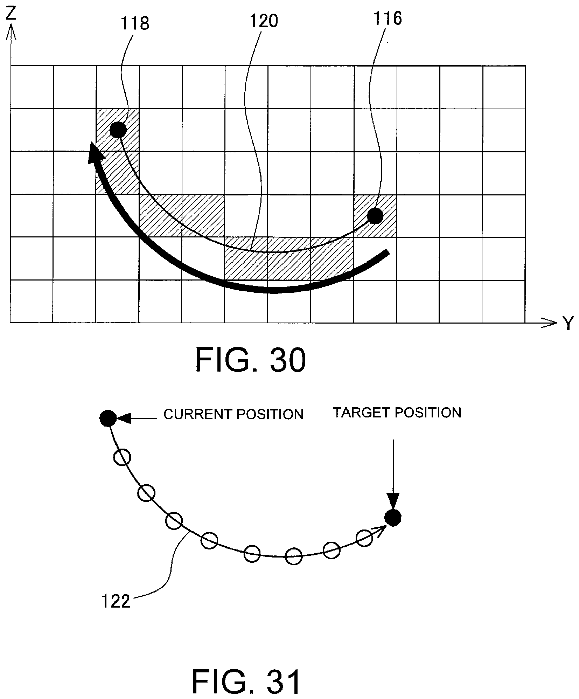

FIG. 30 shows the path of the tilt movement in this process. The path of the tilt movement in this case is represented by a line segment 120 of an arc shape connecting a current position 116 and a target position 118. The line segment 120 is a line segment indicating an arc having the T axis as a rotational center in the Y-Z plane.

For example, the judgment unit 18 draws an approximating arc curve assuming the voxel to be a pixel in the Y-Z plane, and checks whether the value linked to the voxel on the line segment 120 is "1" or "0".

When a voxel (a cell of a square shape in FIG. 30) to which the value of "1" is linked is present on the line segment 120, the judgment unit 18 judges that the dynamic object 102 an the static object 100 overlap each other when the dynamic object 102 is tilted about the T axis in the Y-Z plane. When no voxel to which the value of "1" is linked is present on the line segment 120, the judgment unit 18 judges that the dynamic object 102 and the static object 100 do not overlap each other when the dynamic object 102 is tilted about the T axis in the Y-Z plane.

In apparatuses in which the Z axis is placed below the T axis (for example, the SEM), the movement direction of the Z axis stage does not change with the tilt of the dynamic object about the T axis. Thus, it is not necessary to check the voxels which are present on the slanted line, and it is only necessary to check the voxels in a vertical direction. Even when the T axis is not parallel with the X axis, if the T axis is parallel with the Y axis, the presence or absence of the collision may be judged in the X-Z plane.

### (Eighth Example Configuration)

Rotational movement about the R axis will now be described with reference to FIG. 31. FIG. 31 shows a path 122 when the dynamic object rotationally moves. Here, as one example, it is assumed that the R axis is placed at the uppermost position among the coordinate axes, in the stage including the dynamic object.

When the R axis is placed at the uppermost position, during the rotational movement, only the sample holder and the R axis stage move, and the axis stages placed below the R axis stage do not move. As such, when the presence or absence of overlap during the rotational movement is judged, it is only necessary to judge the presence or absence of overlap between the sample holder and the R axis stage, and the static object. On the other hand, when the tilt movement about the T axis also occurs, it becomes difficult to judge the presence or absence of overlap during the rotational movement on the two-dimensional plane.

A configuration may be considered in which a group of points filling the path of the rotational movement (that is, a group of points representing the trajectory of the rotational movement of the dynamic object) is calculated, the coordinates of the group of points are converted to coordinates indicating the position of an arbitrary axis stage, and the point group information and the voxel group information are then collated. In this case, in order to collate the group of points and the group of voxels, it is necessary to calculate the position of each point included in the group of points with an interval which is smaller than or equal to a size of the voxel (in other words, density). However, as the position of the point included in the group of points which is rotating becomes farther away from the R axis, the path of the rotational movement becomes longer, and, as a consequence, the number of points to be calculated is correspondingly increased. In addition, the amount of calculation is increased according to factors such as the amount of rotation about the R axis, the total number of points for representing the sample holder and the R axis stage, and the like. When the amount of calculation is increased, the time required for the judgment of the presence or absence of overlap is consequently increased, and the speed of judgment is reduced.

In order to handle this, in an eighth example configuration, the generator 14 generates point group information representing the dynamic object for each range of rotational angles about the axis R, which is determined in advance, based on the three-dimensional model of the dynamic object. Specifically, the generator 14 rotates the three-dimensional model of the dynamic object about the R axis by a rotational angle which is determined in advance, and generates a three-dimensional model representing the trajectory of the rotational movement. The generator 14 generates a group of points representing the trajectory of the rotational movement based on the three-dimensional model representing the trajectory of the rotational movement, and generates point group information representing the group of points. Because the trajectory of the rotational movement represents the path of the rotational movement, the three-dimensional model representing the trajectory of the rotational movement is a model which fills the path of the rotational movement. Therefore, the group of points representing the trajectory of the rotational movement is a group of points filling the path of the rotational movement. In the following, the three-dimensional model representing the trajectory of the rotational movement will be referred to as a "rotational model", and the group of points generated based on the rotational model will be referred to as a "rotational group of points". In addition, the three-dimensional model of the dynamic object when the object is not rotated will be referred to as a "standard model".

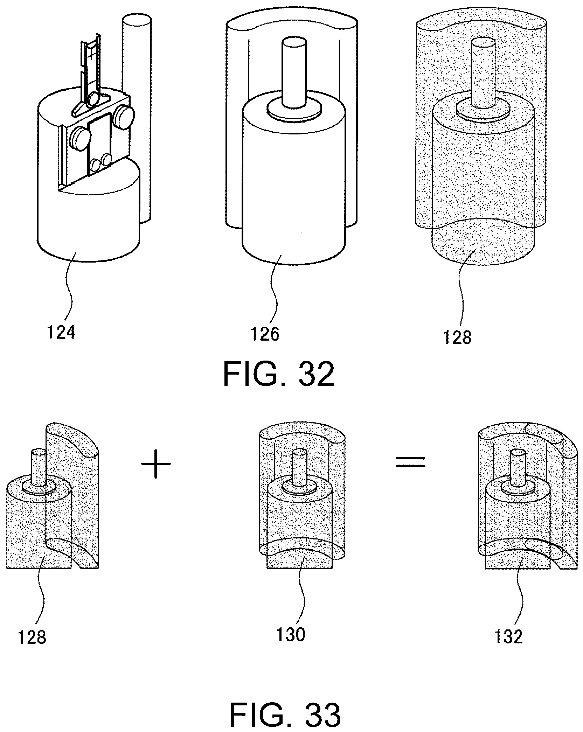

A specific structure of the eighth example configuration will now be described with reference to FIG. 32. FIG. 32 shows a standard model 124 of the dynamic object, a rotational model 126, and a rotational group of points 128.

The standard model 124 is a three-dimensional model representing the sample holder when the sample holder is not rotated about the R axis. That is, the standard model 124 is a three-dimensional model representing the sample holder when the rotational angle is 0°.

The rotational model 126 is a three-dimensional model representing the trajectory of the rotational movement when the standard model 124 is rotated by 90° about the R axis (that is, the path of rotational movement of the standard model 124). The rotational model 126 is a three-dimensional model representing the trajectory of the rotational movement in the range of the rotational angles of 0°~90°; that is, a three-dimensional model covering the range of 0°~90°. The rotational model 126 is generated by the generator 14.

The generator 14 generates the rotational group of points 128 representing the trajectory of the rotational movement based on the rotational model 126, and generates in advance point group information representing the rotational group of points 128. The rotational group of points 128 is a group of points representing the trajectory of the rotational movement in the range of the rotational angles of 0°~90°, and is a group of points covering the range of 0°~90°. The point group information representing the rotational group of points 128 is stored in the storage device 30 in advance.

When the presence or absence of overlap between the dynamic object and the static object is judged when the range of the rotational angles of the dynamic object is the range of 0°~90° (when the presence or absence of overlap is judged in the range of 0°~90°), the judgment unit 18 judges the presence or absence of overlap between the dynamic object and the static object in the range of the rotational angle by collating the point group information representing the rotational group of points 128, and the voxel group information of the static object. With this process, the presence or absence of overlap in the range of rotation of the dynamic object can be judged.

Judgment when the amount of rotation of the dynamic object is larger than an amount of rotation which is presumed in advance will now be described. For example, a case will be considered in which the rotational group of points 128 corresponding to the range of the rotational angles of 0°~90° is generated in advance, and the presence or absence of overlap is to be judged in the range of 0°~360°.

The generator 14 converts the coordinate of the rotational group of points 128 to the coordinate in a target angle range, to generate a rotational group of points covering the target angle range.

More specifically, the generator 14 rotates the rotational group of points 128 by 90° about the R axis, to generate a rotational group of points covering a range of 90°~180°, rotates the rotational group of points 128 by 180°, to generate a rotational group of points covering a range of 180°~270°, and rotates the rotational group of points 128 by 270°, to generate a rotational group of points covering a range of 270°~360°. With this process, a rotational group of points covering the range of 0°~360° is generated, and the judgment unit 18 judges the presence or absence of overlap between the dynamic object and the static object by collating the point group information representing the rotational group of points, and the voxel group information of the static object.

An example process of judgment of the presence or absence of overlap in a range of 0°~140° will now be described with reference to FIG. 33. FIG. 33 shows a group of points of a dynamic object.

As described, the rotational group of points 128 is generated in advance. The generator 14 rotates the rotational group of points 128 by 50° about the R axis, to generate a rotational group of points 130 covering a range of 50°~140°. A rotational group of points 132 is a group of points formed from the rotational groups of points 128 and 130. The judgment unit 18 judges the presence or absence of overlap between the dynamic object and the static object by collating point group information representing the rotational group of points 132 and the voxel group information of the static object. In this manner, when the rotational group of points 128 is generated in advance, the rotational group of points 132 covering the range of 0°~140° can be generated with calculation of one time. When the number of times for calculating the rotational group of points 128 is included, only calculation of a total of two times is required.

On the other hand, when the rotational group of points generated based on the rotational model is not used and a group of points generated based on the standard model is used, the group of points is generated every time after rotating the standard model about the R axis for each unit rotational angle (for example, 0.1° or 1°), and the presence or absence of overlap is judged using the generated group of points. For example, when the presence or absence of overlap in the range of 0°~140° is to be judged, and the unit rotational angle is 1°, calculations of 141 times is required. The amount of calculation is increased as the unit rotational angle is reduced, and, as a result, the time required for the judgment of overlap is increased. In the eighth example configuration, such a calculation is not necessary, and thus, the time required for the judgment can be shortened.

Because the number of coordinate conversion is increased as the range of the rotational angle covered by the rotational model becomes narrower, the amount of calculation is consequently increased and the time required for the judgment is increased. For example, when the rotational model covering a range of 0°~10° is generated in advance, and the presence or absence of overlap is to be judged in a range of 0°~360°, the number of coordinate conversions is 36 times. In this manner, the number of coordinate conversion is increased, but the calculation time is shorter in comparison to the case in which the group of points for filling the path of the rotational movement is calculated without using the rotational model. Because of this, the time required for the judgment can be shortened in comparison to the case in which the rotational model is not used.

Alternatively, a plurality of rotational models having different ranges of the rotational angles may be generated in advance. For example, the generator 14 generates a rotational model covering a range of 0°~90°, and a rotational model covering a range of 0°~10°, and generates a rotational group of points covering the range of 0°~90°, and a rotational group of points covering the range of 0°~10°.

When the range of the rotational angle of the dynamic object is less than 90°, the generator 14 generates the rotational group of points covering the range of the rotational angles based on the rotational group of points covering the range of 0°~10°. The judgment unit 18 collates point group information representing the rotational group of points generated by the generator 14, and the voxel group information of the static object. In this manner, the presence or absence of overlap can be judged in the range of less than 90° by performing the coordinate conversion for the maximum of 9 times.

For example, when the presence or absence of overlap is to be judged in a range of 0°~80°, the generator 14 rotates the rotational group of points covering the range of 0°~10°, a total of 8 times, each time by 10°, to generate a rotational group of points covering the range of 0°~80°. The judgment unit 18 judges the presence or absence of overlap by collating point group information representing the rotational group of points covering the range of 0°~80°, and the voxel group information of the static object.

On the other hand, when the presence or absence of overlap is to be judged in a range of greater than or equal to 90°, the judgment unit 18 judges the presence or absence of overlap by collating the point group information representing the rotational group of points covering the range of 0°~90°, and the voxel group information of the static object.

Alternatively, the generator 14 may generated a rotational group of points according to usage and characteristic of the dynamic object (for example, the sample holder).

For example, when the sample holder is presumed to be used with the rotational angle in a range of 0°~90°, the generator 14 generates in advance a rotational group of points covering the range of 0°~90° as a rotational group of points for the sample holder. When the sample holder is used, the judgment unit 18 judges the presence or absence of overlap using the rotational group of points covering the range of 0°~90°.

When the sample holder is presumed to be used with the rotational angle in a range of 0°~50°, the generator 14 generates in advance a rotational group of points covering the range of 0°~50° as a rotational group of points for the sample holder. When the sample holder is used, the judgment unit 18 judges the presence or absence of overlap using the rotational group of points covering the range of 0°~50°.

Judgment when an amount of rotation of the dynamic object is smaller than an amount of rotation presumed in advance will now be described. When high precision is demanded as precision of the rotational position, and the calculation speed is not regarded to be important, the generator 14 rotates the standard model to generate a three-dimensional model filling the path of the rotational movement, and generates point group information based on the three-dimensional model.

When high precision is not demanded as the precision of the rotational position, and the calculation speed is regarded to be important, the judgment unit 18 judges the presence or absence of overlap using a rotational group of points having the smallest range of the covered angles among the plurality of rotational groups of points generated in advance. For example, a case will be described in which a rotational group of points covering the range of 0°~90° and a rotational group of points covering the range of 0°~10° are generated in advance, and the presence or absence of overlap is to be judged when the rotational angle is 3°. In this case, the judgment unit 18 judges the presence or absence of overlap using the rotational group of points covering the range of 0°~10°. As a result, the rotational angle is in excess of 7°, but the calculation cost is reduced, and the time required for the judgment can be shortened.

The generator 14 may generate in advance a rotational group of points covering a finer range. For example, the generator 14 generates in advance a rotational group of points covering a range of 0°~1°. Using this rotational group of points, the time required for the judgment can be shortened while the precision of the rotational position is improved.

The sample holder described above is a structure having an asymmetric shape about the R axis. When such a structure is included in the dynamic object, it is necessary to finely judge whether or not the dynamic object and the static object collide with each other with the rotation of the dynamic object. In the above-described example configuration, in order to improve the precision of the judgment while preventing reduction of the speed of judgment, a plurality of rotational groups of points having different ranges of the rotational angles are generated in advance.

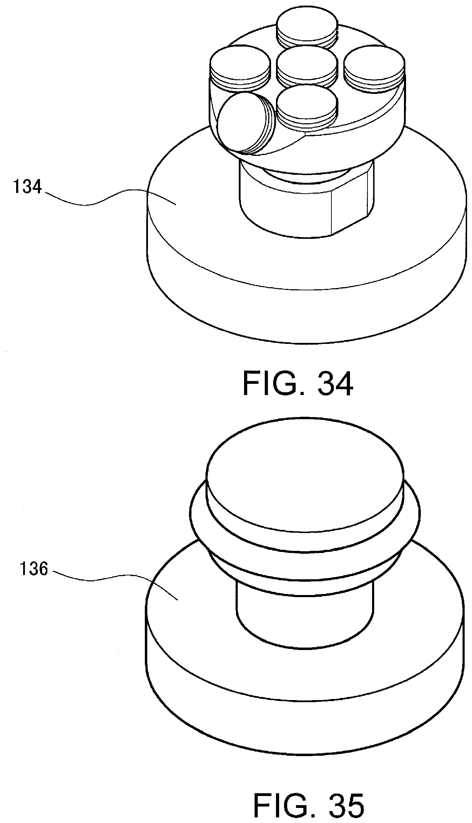

On the other hand, when a sample holder having a rotationally symmetric shape is used, there may be cases in which the influence of the shape on the judgment of the collision is small. In this case, the generator 14 may generate point group information covering a range of 0°~360°. For example, as shown in FIG. 34, when a sample holder 134 having a rotationally symmetric shape is included in the dynamic object, the generator 14 generates a rotational model covering the range of 0°~360°, by rotating the three-dimensional model of the sample holder 134 by 360° about the R axis. FIG. 35 shows a rotational model 136 covering the range of 0°~360°. With the use of the rotational model 136, it becomes unnecessary to finely set the range of the rotational angles, the amount of calculation can be reduced, and the presence or absence of overlap can be judged quicker.

### (Ninth Example Configuration)

In a ninth example configuration, the judgment unit 18 judges the presence or absence of overlap between the dynamic object and the static object by collating, in an order for each of the coordinate axes, voxel group information representing a static object which is present on the movement path of a dynamic object, and point group information representing the dynamic object. When it is judged in judgment for a certain coordinate axis that the dynamic object and the static object overlap each other, the judgment unit 18 changes the coordinate axis for collation, and judges the presence or absence of overlap between the dynamic object and the static object for each of the coordinate axes. In this manner, the judgment unit 18 changes the coordinate axis for collation and performs the judgment when the dynamic object and the static object overlap each other, to search for a path in which the dynamic object and the static object do not overlap each other. The output unit 20 may cause the display to display information indicating the path in which the dynamic object and the static object do not overlap each other.

For example, the dynamic object is moved or rotated in an order of the X axis, the Y axis, and the R axis. That is, the dynamic object is first moved along the X axis to a target position on the X axis, is then moved along the Y axis to a target position on the Y axis, and is then rotated about the R axis to a target angle. In this case, the judgment unit 18 judges the presence or absence of overlap between the dynamic object and the static object for each of the coordinate axes according to the order. For example, when an amount of movement and a direction of movement along the X axis, an amount of movement and a direction of movement along the Y axis, and an amount of movement (that is, an amount of rotation), and a direction of movement (that is, a rotational direction) about the R axis are input in the charged particle beam apparatus 12, information indicating these amounts of movement and directions of movement are output from the charged particle beam apparatus 12 to the collision judgment apparatus 10. Based on this information, the judgment unit 18 calculates the target position of the movement along the X axis, the target position of the movement along the Y axis, and the target angle of rotation about the R axis.

The judgment unit 18 judges whether or not the dynamic object and static object overlap each other when the dynamic object moves along the X axis to the target position. If the dynamic object and the static object do not overlap each other in the movement along the X axis, the judgment unit 18 then judges whether or not the dynamic object and the static object overlap each other when the dynamic object moves along the Y axis to the target position. If the dynamic object and the static object do not overlap each other in the movement along the Y axis, the judgment unit 18 then judges whether or not the dynamic object and the static object overlap each other when the dynamic object rotates about the R axis to the target angle. In each judgment, the output unit causes the display to display information indicating the judgment result.

For example, if it is judged that the dynamic object and the static object overlap each other when the dynamic object moves along the Y axis, the output unit 20 causes the display to display information indicating that the dynamic object and the static object overlap each other due to the movement along the Y axis. The output unit 20 may further cause the display to display information for prompting the user to change the movement path of the dynamic object from the movement path along the Y axis to the movement path along the R axis.

The judgment unit 18 then judges whether or not the dynamic object and the static object overlap each other when the dynamic object rotates about the R axis to the target angle. If it is judged that the dynamic object and the static object do not overlap each other due to the rotational movement, the judgment unit 18 judges whether or not the dynamic object and the static object overlap each other when the dynamic object is moved along the Y axis. In addition, the output unit 20 may cause the display to display information for prompting the user to move the dynamic object along the Y axis after rotating the dynamic object about the R axis.

For example, when it is judged that the dynamic object and the static object do not overlap each other when the dynamic object is moved in the order of the X axis, Y axis, and the R axis, the output unit 20 causes the display to display information indicating as such. In this case, the dynamic object can be moved to the target positions and the target angle without the dynamic object and the static object colliding with each other, if the dynamic object is moved in the order of the X axis, the Y axis, and the R axis.

On the other hand, when it is judged that the dynamic object and the static object overlap each other when the dynamic object is moved in the order of the X axis, the Y axis, and the R axis, and it is further judged that the dynamic object and the static object do not overlap each other when the dynamic object is moved in the order of the X axis, the R axis, and the Y axis, the output unit 20 causes the display to display information indicating as such. If the dynamic object is moved in the order of the X axis, the R axis, and the Y axis according to the information, the dynamic object can be moved to the target positions and the target angle without the dynamic object and the static object colliding with each other.

Each of the example configurations described above may be executed as a single process, or a plurality of the example configurations may be combined and executed.

## Claims

1. A collision judgment apparatus comprising:
judgment means configured to judge presence or absence of overlap between a dynamic object having a position which changes in a sample chamber of a charged particle beam apparatus, and a static object having a position which does not change in the sample chamber, by collating point group information which represents, with a group of points, a three-dimensional shape of the dynamic object, and which includes position information of the dynamic object, and voxel group information which represents, with a group of voxels, a three-dimensional shape of the static object, which includes position information of the static object, and which is formed into a database; and
output means configured to output a result of judgment of the judgment means, wherein
a coordinate system including a three-dimensional orthogonal coordinate system formed from three coordinate axes which are orthogonal to each other is defined, and
the judgment means is configured to judge the presence or absence of overlap between the dynamic object and the static object by collating, for each of the coordinate axes, voxel group information representing the static object which is present on a movement path of the dynamic object, and point group information representing the dynamic object.

2. The collision judgment apparatus according to claim 1, wherein
the coordinate system further includes a tilt axis of the dynamic object, and
the judgment means is configured to judge the presence or absence of overlap between the dynamic object and the static object by collating, for each of the coordinate axes, voxel group information representing the static object which is present on a movement path of the dynamic object, and point group information representing the dynamic object, in a state in which the dynamic object is tilted about the tilt axis.

3. The collision judgment apparatus according to claim 1, wherein
the coordinate system further includes a rotational axis of the dynamic object,
point group information representing the dynamic object is generated for each range of rotational angles which is predetermined, and
the judgment means is configured to judge the presence or absence of overlap between the dynamic object and the static object by collating point group information of the dynamic object according to a range of a rotational angle, and voxel group information representing the static object.

4. The collision judgment apparatus according to claim 1, wherein
the judgment means is configured to:
judge the presence or absence of overlap between the dynamic object and the static object by collating, in an order for each of the coordinate axes, voxel group information representing the static object which is present on a movement path of the dynamic object, and point group information representing the dynamic object; and
when it is judged that the dynamic object and the static object overlap each other, change the order of coordinate axis for collation, and judge the presence or absence of overlap between the dynamic object and the static object by collating, for each of the coordinate axes, voxel group information representing the static object which is present on a movement path of the dynamic object, and point group information representing the dynamic object.

5. The collision judgment apparatus according to claim 1, wherein
voxel group information for each state of the static object is generated, and
the judgment means is further configured to judge the presence or absence of overlap between the dynamic object and the static object by collating voxel group information corresponding to a state of the static object, and point group information representing the dynamic object.

6. The collision judgment apparatus according to claim 5, wherein
the static object includes a structure which reciprocates between a first position and a second position, and
the state of the static object is a state when the structure is at the first position, a state when the structure is at the second position, or a state when the structure is reciprocating between the first position and the second position.

7. The collision judgment apparatus according to claim 1, wherein
the judgment means is further configured to judge the presence or absence of overlap between the dynamic object and the static object by collating point group information representing the dynamic object according to a condition of observation by the charged particle beam apparatus, and voxel group information representing the static object.

8. The collision judgment apparatus according to claim 7, wherein
the condition of observation is a condition related to a voltage applied to a sample which is a target of observation.

9. The collision judgment apparatus according to claim 1, further comprising:
a user interface that receives input of a size of sample mounted on the dynamic object, wherein
the judgment means is configured to judge the presence or absence of overlap between the dynamic object and the static object by collating point group information representing a group of points of the dynamic object reflecting the size received by the user interface, and voxel group information representing the static object.

10. The collision judgment apparatus according to claim 1, further comprising:
calculation means configured to calculate a height of a sample based on a tilt manipulation of the dynamic object on which the sample is mounted, and a movement manipulation of the dynamic object in a height direction, wherein
the judgment means is configured to judge the presence or absence of overlap between the dynamic object and the static object by collating point group information representing a group of points of the dynamic object reflecting a height calculated by the calculation means, and voxel group information representing the static object.

11. A computer-readable recording medium recording a program which, when executed, causes a computer to function as:
judgment means configured to judge presence or absence of overlap between a dynamic object having a position which changes in a sample chamber of a charged particle beam apparatus, and a static object having a position which does not change in the sample chamber, by collating point group information which represents, with a group of points, a three-dimensional shape of the dynamic object, and which includes position information of the dynamic object, and voxel group information which represents, with a group of voxels, a three-dimensional shape of the static object, which includes position information of the static object, and which is formed into a database; and
output means configured to output a result of judgment of the judgment means, wherein
a coordinate system including a three-dimensional orthogonal coordinate system formed from three coordinate axes which are orthogonal to each other is defined, and
the judgment means is configured to judge the presence or absence of overlap between the dynamic object and the static object by collating, for each of the coordinate axes, voxel group information representing the static object which is present on a movement path of the dynamic object, and point group information representing the dynamic object.

12. A method of judging collision, the method comprising:
generating, based on a three-dimensional model representing a three-dimensional shape of a dynamic object having a position which changes in a sample chamber of a charged particle beam apparatus, point group information which represents, with a group of points, the three-dimensional shape of the dynamic object, and which includes position information of the dynamic object;
generating, based on a three-dimensional model representing a three-dimensional shape of a static object having a position which does not change in the sample chamber, point group information which represents, with a group of points, the three-dimensional shape of the static object, and which includes position information of the static object; and
generating, based on the point group information of the static object, voxel group information which represents, with a group of voxels, the three-dimensional shape of the static object, and which is formed into a database, wherein
a coordinate system including a three-dimensional orthogonal coordinate system formed from three coordinate axes which are orthogonal to each other is defined, and
the method further comprises judging presence or absence of overlap between the dynamic object and the static object by collating, for each of the coordinate axes, voxel group information representing the static object which is present on a movement path of the dynamic object, and point group information representing the dynamic object.
